(19) Europäisches Patentamt
European Patent Office
Office européen des brevets

(11) **EP 0 737 866 B1**

(12) **FASCICULE DE BREVET EUROPEEN**

(45) Date de publication et mention
de la délivrance du brevet:
**25.06.2003 Bulletin 2003/26**

(51) Int Cl.[7]: **G01R 33/025**, G01C 17/38

(21) Numéro de dépôt: **96400438.6**

(22) Date de dépôt: **01.03.1996**

(54) **Procédé et dispositif de détermination et de correction d'erreurs dans les mesures d'un magnétomètre**

Verfahren und Vorrichtung zum Ermitteln und Korrigieren von Fehlern in Magnetometermessungen

Method of and device for determining and correcting measurement errors of a magnetometer

(84) Etats contractants désignés:
**DE GB IT**

(30) Priorité: **10.04.1995 FR 9504241**

(43) Date de publication de la demande:
**16.10.1996 Bulletin 1996/42**

(73) Titulaire: **EUROCOPTER**
**13725 Marignane Cédex (FR)**

(72) Inventeurs:
• **Assous, Eric Charles**
**13008 Marseille (FR)**

• **Petillon, Jean-Paul**
**13127 Vitrolles (FR)**

(74) Mandataire: **Bonnetat, Christian**
**CABINET BONNETAT**
**29, rue de St. Pétersbourg**
**75008 Paris (FR)**

(56) Documents cités:
**US-A- 4 611 293**      **US-A- 4 870 602**
**US-A- 4 972 593**      **US-A- 5 182 514**

**Description**

La présente invention concerne un procédé de détermination et de correction d'erreurs dans les mesures d'un magnétomètre monté à bord d'un véhicule, ainsi qu'un dispositif pour la mise en oeuvre de ce procédé et divers systèmes utilisant ledit dispositif.

On sait qu'un magnétomètre monté à bord d'un véhicule, en particulier un aéronef, est généralement soumis à divers types de perturbations, par exemple des perturbations magnétiques et/ou des perturbations mécaniques, qui faussent les mesures de champ magnétique effectuées par ce magnétomètre.

Afin d'obtenir des mesures exactes, il est donc nécessaire, le cas échéant, d'identifier les erreurs engendrées par ces perturbations et de les corriger. Différentes méthodes sont actuellement connues pour effectuer de telles corrections.

Toutefois, pour l'essentiel, ces méthodes connues sont uniquement destinées à corriger des erreurs de mesure dues à des perturbations magnétiques et ne permettent pas de corriger des erreurs présentant d'autres causes et/ou dues à des perturbations non magnétiques.

Ainsi, on connaît par exemple une première méthode usuelle utilisée pour corriger des erreurs de mesure dues à des perturbations magnétiques, qui nécessite pour sa mise en oeuvre une installation précise du magnétomètre sur le véhicule. Selon cette première méthode connue, on définit un modèle de perturbation magnétique de la forme $Hm = [B].H + H_B$, dans lequel :

- Hm représente le champ perturbé mesuré par le magnétomètre ;
- H représente la valeur effective du champ magnétique ;
- [B] est une matrice symétrique tenant compte des perturbations engendrées par les "fers doux", l'absence d'une partie anti-symétrique étant due à l'installation précise et appropriée du magnétomètre sur le véhicule ; et
- $H_B$ représente un champ perturbateur dû aux perturbations engendrées par les "fers durs".

On notera qu'en l'absence de perturbations magnétiques, la matrice [B] représentant alors la matrice identité et le champ perturbateur $H_B$ étant nul, le module du champ magnétique mesuré est constant et l'extrémité décrit une sphère. Sous l'effet de perturbations, cette sphère est transformée en un ellipsoïde décentré.

Ladite première méthode de correction connue préconise d'effectuer les opérations suivantes :

- effectuer un grand nombre de mesures du champ magnétique au cours de variations du cap et de l'assiette du véhicule ;
- déterminer l'ellipsoïde correspondant au mieux aux mesures effectuées ; et
- calculer à partir de l'ellipsoïde ainsi déterminée les composantes de la matrice [B] et du champ perturbateur $H_B$. Le modèle obtenu alors permet de calculer le champ effectif H à partir de mesures ultérieures effectuées par le magnétomètre et soumises à des perturbations magnétiques.

Cette méthode exige toutefois, comme indiqué précédemment, un agencement particulier et très précis du magnétomètre sur le véhicule, ce qui nécessite une fabrication et/ou un réglage spécifiques et coûteux. En outre, la précision obtenue par cette méthode est peu satisfaisante. Ces inconvénients sont partiellement résolus par une seconde méthode connue qui est soumise à des contraintes beaucoup moins importantes que la méthode précédente concernant l'agencement du magnétomètre sur le véhicule. Cette seconde méthode connue, qui permet également de corriger uniquement des erreurs de mesures dues à des perturbations magnétiques, est mise en oeuvre en deux étapes successives :

- dans une première étape, on détermine, à partir d'un procédé semblable à celui de la méthode précédente, une mesure conservant la constance de la norme du champ, ladite mesure n'étant plus affectée que par un mésalignement ; et
- dans une seconde étape, on détermine la composante non symétrique de la matrice de transformation semblable à la matrice [B] précédente, à partir des variations de la composante verticale du champ magnétique, cette étape étant mise en oeuvre en utilisant des mesures d'assiettes.

Cette seconde méthode connue présente de nombreux inconvénients. En particulier, la mise en oeuvre des deux étapes précitées suppose une procédure de manoeuvres complexe et longue du véhicule, au cours de laquelle sont effectuées les mesures utilisées.

Afin de remédier aux inconvénients des deux méthodes connues précitées, la demanderesse a décrit, dans la demande de brevet 94 15231 déposée le 19 décembre 1994, un procédé de correction d'erreurs de mesure d'un magnétomètre. Toutefois, ce procédé avantageux permet uniquement la correction des erreurs dues à des perturbations magnétiques, ainsi que des erreurs dues à un mauvais alignement du trièdre de référence du magnétomètre par rapport au trièdre de référence du véhicule.

Par conséquent, il n'existe actuellement aucune méthode connue permettant de corriger, de façon satisfaisante, des erreurs dues, au moins en partie, à d'autres types de perturbations que celles décrites précédemment.

Par ailleurs, par le document US-5 182 514, on connaît une méthode et un système pour compenser des composantes d'un champ magnétique mesuré par un magnétomètre, qui sont induites par des manoeuvres. A cet effet, les champs magnétiques mesurés durant une série de manoeuvres sélectionnées de l'aéronef, sont transformés dans des signaux représentatifs des propriétés magnétiques de l'aéronef. Ensuite, ces signaux sont combinés avec des signaux représentatifs de l'attitude de l'aéronef de manière à obtenir un signal de compensation. Ce signal de compensation peut être appliqué directement à la sortie du magnétomètre ou peut être utilisé pour commander un jeu de bobines compensatrices.

La présente invention a pour objet de pallier la lacune précitée de l'état de la technique. Elle concerne un procédé permettant de corriger, de façon générale et très précise, des erreurs dues à des perturbations déterminées et variées dans les mesures d'un magnétomètre monté à bord d'un véhicule, en particulier un aéronef.

A cet effet, selon l'invention, ledit procédé est remarquable en ce que :

- on définit un modèle théorique correcteur des erreurs de mesure du magnétomètre de la forme :

$$Hc = [A].Hm + \sum_{i=1}^{i=n} ( [C]i.[E]i ) + Hp,$$

$\underline{n}$ étant un nombre entier supérieur ou égal à 1,
dans lequel :

- . Hc est le champ corrigé,
- . [A] est une matrice à déterminer,
- . Hm est la valeur mesurée par le magnétomètre du champ magnétique dans un référentiel lié audit véhicule,
- . les éléments [C]i sont des matrices à déterminer de dimensions respectives (3xmi), $\underline{mi}$ étant un nombre entier supérieur ou égal à 1,
- . les éléments [E]i sont des matrices de dimensions respectives (mix1) dont les coefficients sont des mesures de paramètres perturbateurs ou des combinaisons de telles mesures, et
- . Hp est un champ perturbateur à déterminer ;

- on considère que le champ corrigé Hc est le champ terrestre défini dans le référentiel du véhicule de sorte que :

$$[A].Hm + \sum_{i=1}^{i=n} ([C]i. [E]i) + Hp = [M].H$$

avec :

- . H la valeur effective du champ magnétique dans un référentiel de base, et
- . [M] une matrice de passage dudit référentiel de base audit référentiel du véhicule ;

- on effectue des mesures Hm successives du champ magnétique au moyen du magnétomètre lors d'évolutions du véhicule ;

- on détermine les coefficients des différentes matrices [E]i, à partir des mesures des paramètres perturbateurs, effectuées simultanément aux mesures Hm ;

- on détermine les coefficients de la matrice de passage [M] ;

- on définit un vecteur d'erreur E de composantes Ex, Ey et Ez, défini par la relation :

$$E = [M].H - ([A].Hm + \sum_{i=1}^{i=n} ([C]i.[E]i) + Hp)$$

- on définit une erreur globale $E^2 = Ex^2 + Ey^2 + Ez^2$

- on définit un système d'équations formé de <u>m</u> équations du type $(\partial \Sigma E^2)/\partial cl = 0$, $1 = 1$ à m, $(\partial \Sigma E^2)/\partial cl$ correspondant à la dérivée partielle de la somme des erreurs globales $\Sigma E^2$, pour toutes les mesures, par rapport à un coefficient <u>cl</u>, les différents coefficients <u>cl</u> représentant les coefficients à déterminer dudit modèle théorique, à savoir les coefficients de la matrice [A], des matrices [C]i et du vecteur Hp, ainsi qu'au moins une composante du champ magnétique effectif H ;

- on résout ledit système d'équations de manière à obtenir lesdits coefficients <u>cl</u>, dont ladite composante du champ magnétique effectif H ; et

- on utilise le modèle correcteur obtenu à partir desdits coefficients pour corriger les erreurs dues à des perturbations déterminées dans les mesures dudit magnétomètre.

Ainsi, grâce à l'invention, on obtient une méthode générale permettant de déterminer et de corriger de façon précise des erreurs de mesure d'un magnétomètre, dues à des perturbations variées et multiples, comme on le verra plus en détail ci-après à partir de différents modes de réalisation particulièrement avantageux.

De plus, grâce à l'invention, la détermination du modèle correcteur est effectuée en une seule étape, ce qui entraîne une mise en oeuvre simplifiée, en particulier en ce qui concerne la procédure de manoeuvres du véhicule, au cours de laquelle sont effectuées les mesures.

En outre, le procédé conforme à l'invention permet de déterminer, simultanément au calcul dudit modèle correcteur, au moins une composante du champ magnétique effectif dans le référentiel de base.

On notera que les calculs effectués lors de la mise en oeuvre du procédé sont simplifiés dans le cas où on ne détermine qu'une seule composante dudit champ magnétique.

En effet, dans les modes de réalisation pour lesquels on ne détermine que la composante verticale du champ magnétique, on utilise avantageusement comme erreur globale $E^2 = Ez^2$, de sorte que seuls les coefficients de la troisième ligne de la matrice $[M]^{-1}$ sont utilisés, ladite matrice $[M]^{-1}$ étant la matrice de passage dudit référentiel du véhicule audit référentiel de base, lesdits coefficients étant déterminés à partir des assiettes longitudinale et transversale dudit véhicule.

En revanche, dans les modes de réalisation pour lesquels on détermine les trois composantes du champ magnétique, les coefficients de la matrice [M] sont déterminés de façon avantageuse à partir des assiettes longitudinale et transversale, ainsi qu'à partir du cap dudit véhicule.

Avantageusement, la valeur de cap utilisée dans ce cas peut correspondre soit à une valeur de cap géographique, soit à une valeur de cap affectée d'une erreur constante quelconque, telle que celle délivrée par une centrale d'attitude et de cap en mode gyroscopique libre.

Pour bien mettre en évidence la variété et la multiplicité de corrections possibles par le procédé conforme à l'invention, on présente ci-dessous plusieurs modes de réalisation particulièrement avantageux, ces différents modes de réalisation pouvant être réalisés simultanément lors d'une mise en oeuvre unique dudit procédé.

A titre d'exemple, la présente invention permet de corriger des erreurs de mesure du magnétomètre dues à des perturbations mécaniques, en particulier des déformations de l'élément porteur du magnétomètre qui sont susceptibles de modifier l'alignement de ce dernier, ce qui provoque alors des erreurs de mesure.

En premier lieu, dans le cas où le magnétomètre est monté sur un élément porteur, du type poutre de queue d'un hélicoptère, susceptible d'être déformé lorsqu'il est soumis à des contraintes mécaniques variables, selon l'invention, pour déterminer et corriger les erreurs dues à de telles déformations dans les mesures du magnétomètre, on utilise de façon avantageuse dans le modèle théorique le produit de la matrice [C] de dimension (3,5) et de la matrice [E] de dimension (5,1), telles que :

$$[C] \;=\; \begin{bmatrix} 0 & -Cez & 0 & 0 & Cey \\ Cez & 0 & -Cex & 0 & 0 \\ 0 & Cex & 0 & -Cey & 0 \end{bmatrix}$$

et

$$[E] \;=\; \begin{bmatrix} Fv.Hmx \\ Fv.Hmy \\ Fv.Hmz \\ Fh.Hmx \\ Fh.Hmz \end{bmatrix}$$

avec :

- Fv : l'effort latéral engendré sur l'élément porteur,
- Fh : l'effort vertical engendré sur l'élément porteur,
- Cex : le coefficient d'élasticité de torsion de l'élément porteur,
- Cey : le coefficient d'élasticité de flexion en tangage de l'élément porteur,
- Cez : le coefficient d'élasticité de flexion en lacet de l'élément porteur, et
- Hmx, Hmy et Hmz : les composantes respectives du champ mesuré Hm dans le référentiel du véhicule.

En second lieu, dans le cas où le magnétomètre est monté sur une aile d'un avion, par exemple d'un avion de transport, selon l'invention, pour déterminer et corriger les erreurs dues à un défaut d'alignement du magnétomètre provoqué par le battement de ladite aile, on utilise de façon avantageuse, dans le modèle théorique, le produit des matrices [C] et [E], telles que

$$[C] \;=\; \begin{bmatrix} 0 & 0 \\ -Cox & 0 \\ 0 & Cox \end{bmatrix} \qquad \text{et } [E] \;=\; \begin{bmatrix} Pz.Hmz \\ \\ Pz.Hmy \end{bmatrix}$$

dans lesquels :

- Cox est le coefficient d'élasticité en battement de ladite aile,
- Pz est la portance de ladite aile, qui est définie avantageusement par la relation Pz = M*.gz, avec M* la masse du véhicule et gz le facteur de charge vertical, et
- Hmy et Hmz sont les valeurs des composantes latérale et verticale du champ magnétique mesuré Hm.

Outre la prise en compte de perturbations mécaniques, telles que celles présentées ci-dessus, la présente invention permet également de remédier aux conséquences dommageables d'autres types de perturbations, en particulier des perturbations d'origine magnétique comme précisé ci-après.
Ainsi, par exemple, dans le cas où ledit véhicule est un hélicoptère dont le rotor présente un résidu de magnétisation, selon un mode de réalisation particulièrement avantageux de l'invention, pour déterminer et corriger les erreurs dues à des variations des perturbations magnétiques provoquées par ledit rotor aimanté soumis à des contraintes mécaniques élevées, on utilise de façon avantageuse dans le modèle théorique le produit des matrices [C] et [E], telles que

$$[C] = \begin{bmatrix} Hcx \\ Hcy \\ Hcz \end{bmatrix} \qquad et\ [E] = Cr,$$

Cr étant le couple rotor et Hcx, Hcy et Hcz des coefficients de proportionnalité à déterminer.

Par ailleurs, avantageusement, pour déterminer et corriger les erreurs dues à des perturbations magnétiques engendrées par la présence d'au moins un équipement consommateur de courant continu à proximité dudit magnétomètre, on utilise dans le modèle théorique le produit des matrices [C] et [E], telles que

$$[C] = \begin{bmatrix} Hix \\ Hiy \\ Hiz \end{bmatrix} \qquad et\ [E] = I,$$

I étant le courant continu consommé par ledit équipement et Hix, Hiy et Hiz des coefficients de proportionnalité à déterminer.

En outre, un mode de réalisation avantageux de l'invention permet de déterminer et de corriger un défaut de linéarité des mesures du magnétomètre selon au moins l'un des trois axes de mesure possibles dudit magnétomètre.

A cet effet, selon l'invention, on détermine une approximation polynomiale de la fonction non linéaire reproduisant ce défaut de linéarité et, pour déterminer le terme correcteur d'une harmonique $\underline{n}$ de ladite approximation polynomiale, on utilise dans le modèle théorique le produit des matrices [C] et [E], telles que

$$[C] = \begin{bmatrix} axn & 0 & 0 \\ 0 & ayn & 0 \\ 0 & 0 & azn \end{bmatrix} \qquad et\ [E] = \begin{bmatrix} Hmx^n \\ Hmy^n \\ Hmz^n \end{bmatrix}$$

avec :

- axn, ayn et azn, des coefficients à déterminer représentant les amplitudes respectives, selon les trois axes de mesure du magnétomètre, des corrections de non-linéarité d'ordre $\underline{n}$ ; et
- $Hmx^n$, $Hmy^n$ et $Hmz^n$, les puissances $n^{\text{ièmes}}$ des composantes respectives du champ mesuré Hm selon les trois axes de mesure du magnétomètre.

Lors de la mise en oeuvre du procédé conforme à l'invention, on a supposé que le champ magnétique est constant pour toutes les mesures de champ magnétique effectuées. Ceci n'est toutefois pas toujours vérifié en pratique. Aussi, un mode de réalisation avantageux de l'invention permet de déterminer les variations locales des composantes du champ magnétique terrestre, ce qui permet d'améliorer la précision du modèle correcteur obtenu par la présente invention.

A cet effet, selon l'invention, on utilise dans le modèle théorique le produit de la matrice [C], dont les coefficients représentent les différents gradients desdites composantes du champ magnétique terrestre, et de la matrice [E], dont les coefficients sont calculés à partir des coefficients de la matrice de passage [M] et à partir de la position dans un repère déterminé dudit véhicule lors des mesures du magnétomètre.

Finalement, un dernier mode de réalisation de l'invention permet de déterminer et de corriger les biais de gyromètres, dont les mesures sont utilisées notamment pour déterminer les coefficients de la matrice [M], ce qui met bien en évidence la diversité de mises en oeuvre possibles de l'invention qui n'est pas limitée à la seule correction d'erreurs dues à des perturbations magnétiques et/ou mécaniques, telles que celles précisées ci-dessus.

Selon ce dernier mode de réalisation, de façon avantageuse, on utilise dans le modèle théorique le produit des matrices [C] et [E], telles que

$$[C] = \begin{bmatrix} 0 & -\Delta wz & \Delta wy \\ \Delta wz & 0 & -\Delta wx \\ -\Delta wy & \Delta wx & 0 \end{bmatrix} \quad \text{et} \quad [E] = \begin{bmatrix} Hmx.t \\ Hmy.t \\ Hmz.t \end{bmatrix}$$

dans lesquels :

- $\Delta wx$, $\Delta wy$ et $\Delta wz$ sont les biais desdits gyromètres à déterminer,
- Hmx, Hmy et Hmz sont les composantes respectives du champ mesuré Hm dans le référentiel du véhicule, et
- t est l'instant auquel est effectuée la mesure.

La présente invention concerne également un dispositif pour la mise en oeuvre du procédé précité.

Selon l'invention, ledit dispositif est remarquable en ce qu'il comporte :

- un premier module de calcul recevant des données disponibles sur ledit véhicule et susceptible de déterminer à partir de ces données les coefficients des matrices [E]i ;
- un second module de calcul susceptible de calculer les coefficients de la matrice de passage [M], utiles pour la mise en oeuvre de l'invention, à partir des assiettes et si nécessaire du cap du véhicule ; et
- un module principal de calcul relié auxdits premier et second modules de calcul, ainsi qu'au magnétomètre, et susceptible de déterminer ledit modèle correcteur et ledit champ magnétique effectif.

On notera que la présente invention concerne en outre deux systèmes comportant le dispositif conforme à l'invention, à savoir, d'une part, un système de référence d'attitude et de cap embarqué à bord d'un aéronef et comportant un magnétomètre utilisé pour corriger une éventuelle dérive de la mesure du cap et, d'autre part, une centrale inertielle d'un aéronef, qui est associée à un magnétomètre.

Dans le système de référence d'attitude et de cap, le dispositif conforme à l'invention est utilisé pour corriger les erreurs de mesure dudit magnétomètre, tandis que, dans la centrale inertielle, ledit dispositif est utilisé pour déterminer de façon précise, en collaboration avec ledit magnétomètre, le champ magnétique terrestre, ainsi que pour corriger les erreurs de mesure dudit magnétomètre.

Les figures du dessin annexé feront bien comprendre comment l'invention peut être réalisée. Sur ces figures, des références identiques désignent des éléments semblables.

La figure 1 montre de façon schématique un véhicule comportant un dispositif conforme à l'invention.

La figure 2 est le schéma synoptique du dispositif conforme à l'invention.

La figure 3 est une vue latérale de la poutre de queue d'un hélicoptère portant un magnétomètre.

La figure 4 est une vue transversale de la poutre de queue de la figure 3.

La figure 5 est une vue de dessus de la poutre de queue de la figure 3.

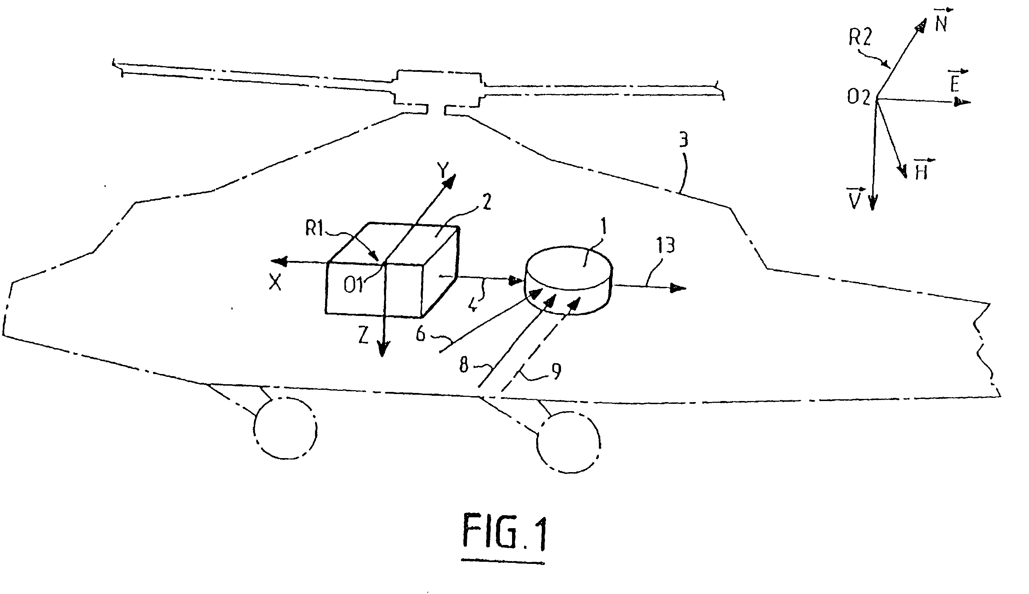

Le dispositif 1 conforme à l'invention est destiné à corriger des erreurs dans les mesures d'un magnétomètre 2 monté à bord d'un véhicule 3 qui est représenté schématiquement sous la forme d'un hélicoptère sur la figure 1.

Le magnétomètre 2 est susceptible de mesurer, dans un référentiel R1 qui est associé audit véhicule 3, les composantes d'une grandeur physique magnétique orientée et d'amplitude constante localement, représentée par un vecteur, tel le vecteur H orienté dans l'exemple représenté selon le gradient du potentiel magnétique terrestre. Le champ magnétique Hm mesuré par ledit magnétomètre 2 vérifie la relation Hm = [M].H, dans laquelle H représente la valeur effective du champ magnétique dans un référentiel de base R2 et [M] représente la matrice de passage dudit référentiel de base R2 audit référentiel du véhicule R1.

Ledit référentiel de base R2 peut par exemple être formé par trois axes $\vec{V}$, $\vec{N}$ et $\vec{E}$ définis comme suit :

- $\vec{V}$ est un axe parallèle au gradient du champ de gravité terrestre, orienté vers le centre de la terre, et donnant la verticale locale ;
- $\vec{N}$ est un axe horizontal donnant le nord géographique ou directionnel ; et
- $\vec{E}$ est un axe donnant l'est, tel que représenté sur la figure 1.

De façon connue, le passage de l'un à l'autre de ces référentiels R1 et R2 nécessite trois rotations successives définies par les angles d'Euler $\psi$, $\Theta$ et $\Phi$ non représentés, parmi lesquels :

- $\psi$ est l'angle de cap,
- $\Theta$ est l'angle d'assiette longitudinale, et

- Φ est l'angle d'assiette transversale.

Ces trois rotations s'écrivent selon la matrice usuelle des angles d'Euler, c'est-à-dire la matrice de passage $[M]^{-1}$ permettant le passage du référentiel R1 vers le référentiel R2, définie comme suit :

$$[M]^{-1} =$$
$$\begin{vmatrix} \cos\psi.\cos\Theta & \cos\psi.\sin\Theta.\sin\Phi - \sin\psi.\cos\Phi & \sin\psi.\sin\Phi + \cos\psi.\sin\Theta.\cos\Phi \\ \sin\psi.\cos\Theta & \cos\psi.\cos\Phi + \sin\psi.\sin\Theta.\sin\Phi & \sin\psi.\sin\Theta.\cos\Phi - \cos\psi.\sin\Phi \\ - \sin\Theta & \cos\Theta.\sin\Phi & \cos\Theta.\cos\Phi \end{vmatrix}$$

Toutefois, un tel magnétomètre 2 est souvent soumis à diverses perturbations, par exemple des perturbations mécaniques ou des perturbations magnétiques, de sorte que les mesures effectuées présentent des erreurs.

Le dispositif 1 conforme à l'invention est destiné à déterminer simultanément toutes les erreurs existantes, quelles que soient les origines de ces erreurs, et à les corriger.

On décrit ci-après un premier mode de mise en oeuvre de l'invention permettant de déterminer simultanément :

- un modèle correcteur permettant la détermination et la correction de toutes les erreurs apparaissant dans les mesures du magnétomètre 2 ; et
- les trois composantes du champ magnétique H dans le référentiel de base.

A cet effet, on définit tout d'abord un modèle théorique correcteur des erreurs de mesure du magnétomètre de la forme :

$$Hc = [A].Hm + \sum_{i=1}^{i=n} ([C]i.[E]i) + Hp \qquad (1)$$

$n$ étant un nombre entier supérieur ou égal à 1,
dans lequel, en plus de l'élément Hm précité :

- Hc est le champ corrigé ;
- [A] est une matrice à déterminer, prenant en compte les perturbations dites de "fers doux" et les mésalignements, sans limitation de valeur angulaire ;
- les éléments [C]i sont des matrices à déterminer de dimensions respectives (3xmi), $mi$ étant un nombre entier supérieur ou égal à 1 ;
- les éléments [E]i sont des matrices de dimensions respectives (mixl) dont les coefficients sont des mesures de paramètres perturbateurs ou des combinaisons de telles mesures, comme précisé ci-dessous ; et
- Hp est un champ perturbateur à déterminer.

Ainsi, le modèle théorique comporte la somme de produits matriciels :

$$\sum_{i=1}^{i=n} ([C]i.[E]i) = ([C]1.[E]1) + ([C]2.[E]2) + ... + ([C]n.[E]n)$$

avec :

$$[C]i \; = \; \begin{bmatrix} c11 & c12 & ... & c1mi \\ c21 & c22 & ... & c2mi \\ c31 & c32 & ... & c3mi \end{bmatrix}_i$$

et

$$[E]i \; = \; \begin{bmatrix} E1 \\ E2 \\ . \\ . \\ . \\ Emi \end{bmatrix}_i$$

On considère que le champ corrigé Hc est le champ terrestre projeté dans le référentiel du véhicule de sorte que :

$$[A].Hm \; + \; \sum_{i=1}^{i=n} \; ([C]i.[E]i) \; + \; Hp \; = \; [M].H \qquad (2)$$

Puis on effectue, lors de manoeuvres dudit véhicule 3, des mesures successives du champ magnétique, au moyen du magnétomètre 2, et des mesures de cap et d'assiettes au moyen d'un système approprié, comme par exemple une centrale de cap et d'attitude en mode gyroscopique libre non représentée et montée sur ledit véhicule 3, ainsi qu'éventuellement, c'est-à-dire si elles sont nécessaires pour la mise en oeuvre de l'invention, des mesures permettant de déterminer les coefficients des éléments [E]i, tel que précisé ci-après à partir de modes de réalisation particuliers.

Ces manoeuvres peuvent correspondre, par exemple pour un aéronef, à deux virages, à droite puis à gauche, de 360° avec un roulis de l'ordre de 30°.

Les mesures d'assiettes et éventuellement de cap sont utilisées pour calculer la matrice de passage [M] telle que définie précédemment.

L'expression précédente (2) du modèle théorique peut s'écrire sous la forme du système suivant :

$$\sum_{j=1}^{j=p} (\alpha j) \; = \; R_{11}.Hn \; + \; R_{12}.He \; + \; R_{13}.Hv$$

$$\sum_{j=1}^{j=p} (\beta j) \; = \; R_{21}.Hn \; + \; R_{22}.He \; + \; R_{23}.Hv$$

$$\begin{array}{c} j=p \\ \sum \\ j=1 \end{array} (\gamma j) \;=\; R_{31}.Hn \;+\; R_{32}.He \;+\; R_{33}.Hv$$

dans lequel :

- les termes $R_{pq}$, (P = 1, 2, 3 et q = 1, 2, 3) sont les coefficients de la matrice [M] ;
- Hn, He et Hv sont les composantes du vecteur H ;
- les sommes des termes $(\alpha j)$, des termes $(\beta j)$ et des termes $(\gamma j)$ sont les expressions de gauche respectivement des trois lignes de ladite expression (2) ; et

$$- \quad p \;=\; \begin{array}{c} i=n \\ \sum \\ i=1 \end{array} (mi)+4$$

On remarquera que ce système ne peut être déterminé qu'à une constante multiplicative près. Pour lever l'indétermination, on peut diviser les différentes équations par un coefficient apparaissant dans chacune d'elles, par exemple Hn, He ou Hv. Toutefois, comme les coefficients He et Hv sont susceptibles de présenter des valeurs très faibles dans certaines régions du globe terrestre, ce qui'risque de poser des problèmes de calcul, on divise de préférence lesdites équations par Hn de manière à obtenir le système suivant :

$$\begin{array}{c} j=p \\ \sum \\ j=1 \end{array} (\alpha j)/(Hn) \;=\; R_{11} \;+\; R_{12}.he \;+\; R_{13}.hv$$

$$\begin{array}{c} j=p \\ \sum \\ j=1 \end{array} (\beta j)/(Hn) \;=\; R_{21} \;+\; R_{22}.he \;+\; R_{23}.hv$$

$$\begin{array}{c} j=p \\ \sum \\ j=1 \end{array} (\gamma j)/(Hn) \;=\; R_{31} \;+\; R_{32}.he \;+\; R_{33}.hv$$

avec he = He/Hn et hv = Hv/Hn.

Puis on considère le vecteur d'erreur E de composantes Ex, Ey et Ez, défini par la relation :

$$E \;=\; [M].H \;-\; \left([A].Hm \;+\; \begin{array}{c} i=n \\ \sum \\ i=1 \end{array} ([C]i.[E]i) \;+\; Hp\right)$$

Toutefois, afin de pouvoir utiliser le système précédent, on détermine un vecteur d'erreur modifié $\varepsilon$ de composantes $\varepsilon x$, $\varepsilon y$ et $\varepsilon z$ vérifiant la relation $\varepsilon = E / Hn$.

A partir desdites composantes, on détermine une erreur globale de la forme $E^2 = Ex^2 + Ey^2 + Ez^2$ ou de la forme $\varepsilon^2 = \varepsilon x^2 + \varepsilon y^2 + \varepsilon z^2$.

Puis on définit un système d'équations formé de m équations du type $(\partial \Sigma \varepsilon^2)/\partial cl = 0$, 1 = 1 à m, ou du type

$(\partial \Sigma E^2)/\partial cl = 0$, $(\partial \Sigma \varepsilon^2)/\partial cl$ correspondant à la dérivée partielle de la somme des erreurs globales $\Sigma \varepsilon^2$, pour toutes les mesures, par rapport à un coefficient cl, les différents coefficients cl représentant les coefficients à déterminer dudit modèle théorique de perturbation, à savoir les coefficients de la matrice [A], des n matrices [C]i et du vecteur Hp, ainsi que les composantes du champ magnétique effectif H ; et on résout par une méthode numérique ledit système d'équations.

Finalement, afin de retrouver des coefficients de dimensions exactes, on divise encore tous les coefficients obtenus précédemment par un diviseur approprié, à savoir par exemple le terme Q11 = (A11)/Hn.

Les coefficients obtenus alors constituent le modèle correcteur permettant de déterminer les valeurs exactes du champ magnétique à partir de valeurs de champ mesurées par le magnétomètre 2, c'est-à-dire de corriger les erreurs desdites valeurs de champ mesurées.

Le mode de réalisation de l'invention décrit ci-dessus permet donc de déterminer simultanément ledit modèle correcteur et les trois composantes du champ magnétique terrestre.

On décrit ci-dessous un mode de réalisation simplifié n'utilisant pas de référence de cap, et ne permettant de déterminer, en plus dudit modèle correcteur, que la composante verticale Hv dudit champ magnétique terrestre.

A cet effet, on écrit l'expression (2) du modèle théorique sous la forme :

$$[M]^{-1} \cdot ([A].Hm + \sum_{i=1}^{i=n} ([C]i.[E]i) + Hp = H$$

c'est-à-dire :

$$[M]^{-1} \cdot \begin{vmatrix} \sum_{j=1}^{j=p} (\alpha j) \\ \sum_{j=1}^{j=p} (\beta j) \\ \sum_{j=1}^{j=p} (\gamma j) \end{vmatrix} = \begin{vmatrix} Hn \\ He \\ Hv \end{vmatrix}$$

Dans la présente hypothèse, les composantes Hn et He du champ magnétique effectif H sont inaccessibles du fait de l'absence de référence de cap. Par conséquent, seule la troisième équation du système précédent est exploitable à des fins d'identification d'une composante du champ magnétique, ladite troisième équation s'écrivant :

$$R_{31}^* \cdot (\sum_{j=1}^{j=p} (\alpha j)) + R_{32}^* \cdot (\sum_{j=1}^{j=p} (\beta j)) + R_{33}^* \cdot (\sum_{j=1}^{j=p} (\gamma j)) = Hv$$

$R_{31}^*$, $R_{32}^*$ et $R_{33}^*$ sont les trois composantes de la troisième ligne de la matrice de passage $[M]^{-1}$ définie ci-dessus, c'est-à-dire que :

$$R_{31}^* = - \sin\Theta$$

$$R_{32}^* = \cos\Theta . \sin\Phi$$

$$R_{33}^* = \cos\Theta . \cos\Phi .$$

Ces coefficients $R_{31}^*$, $R_{32}^*$ et $R_{33}^*$ sont donc définis uniquement à partir des angles d'assiettes $\Theta$ et $\Phi$, et non à partir de l'angle de cap $\psi$.

Comme dans le mode de réalisation précédent, cette équation admet une infinité de solutions à une constante multiplicative près. Pour lever l'indétermination existante, on divise les deux membres de l'équation par Hv.

On notera que, dans ce cas, on détermine uniquement la composante $\varepsilon z$ du vecteur d'erreur $\varepsilon$. Puis on définit un système d'équations formé d'équations du type $(\partial\Sigma\varepsilon z^2)/\partial cl = 0$, les coefficients <u>cl</u> représentant de nouveau les coefficients à déterminer du modèle théorique (1), et on résout ce système de façon usuelle.

Les coefficients ainsi calculés sont divisés par un diviseur approprié pour obtenir les dimensions correctes et le modèle correcteur recherché.

La mise en oeuvre est donc identique à celle décrite précédemment.

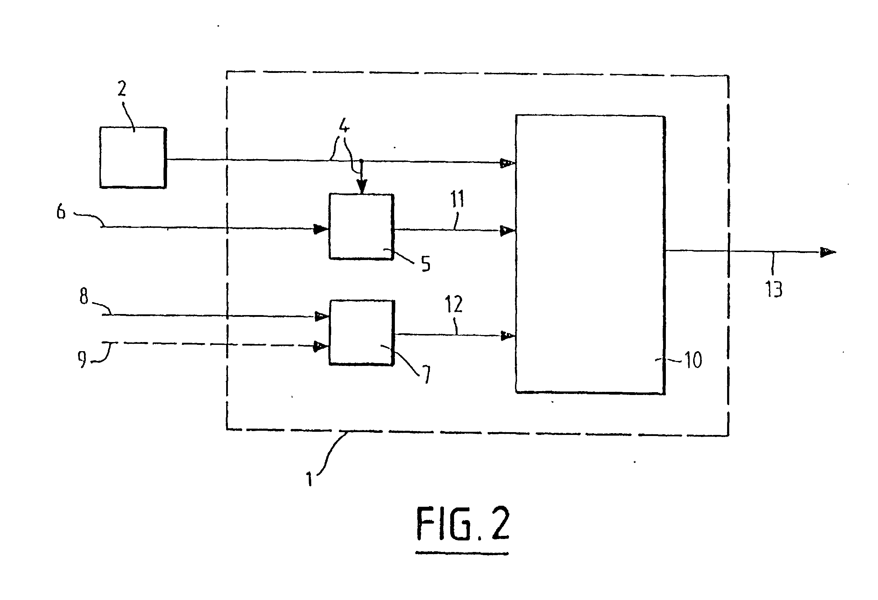

Pour ces mises en oeuvre du procédé conforme à l'invention, le dispositif 1, qui est relié par une liaison 4 au magnétomètre 2, comporte, selon l'invention et tel que représenté sur la figure 2 :

- un module de calcul 5 relié au magnétomètre 2 par ladite liaison 4 et recevant, par l'intermédiaire d'une liaison multiple 6, des données disponibles sur le véhicule 3 et précisées ci-après pour des modes de réalisation particuliers, ledit module de calcul 5 étant susceptible de déterminer les coefficients des matrices [E]i ;
- un module de calcul 7 recevant d'un dispositif approprié non représenté, d'une part, les valeurs des assiettes du véhicule 3 par l'intermédiaire d'une liaison 8 et, d'autre part, éventuellement, c'est-à-dire si elle est nécessaire pour la mise en oeuvre de l'invention, la valeur du cap du véhicule 3 par l'intermédiaire d'une liaison 9, ledit module de calcul 7 étant susceptible de calculer les coefficients de la matrice de passage [M] utilisés lors de la mise en oeuvre de l'invention ; et
- un module principal de calcul 10 relié auxdits modules de calcul 5 et 7 et audit magnétomètre 2, par l'intermédiaire respectivement de liaisons 11 et 12 et de la liaison 4, ledit module principal de calcul 10 étant susceptible de déterminer ledit modèle correcteur et ledit champ magnétique effectif et pouvant transmettre les résultats obtenus par une liaison 13, par exemple à un dispositif utilisateur non représenté.

On notera que le module de calcul 5 est relié en particulier à des dispositifs de mesure et/ou à des capteurs qui lui fournissent, par l'intermédiaire de la liaison multiple 6, des données spécifiques précisées ci-dessous et traitées par ledit module de calcul 5. Toutefois, dans certains cas, comme on le verra également ci-après, les données disponibles correspondent telles quelles aux coefficients recherchés des matrices [E]i de sorte que le module de calcul 5 ne sert alors qu'à transmettre ces données au module de calcul principal 10.

Bien entendu, ledit module principal de calcul 10 et lesdits modules de calcul 5 et 7 peuvent être implantés soit dans un calculateur unique, soit dans des calculateurs différents.

Avant de préciser différents modes de réalisation particulièrement avantageux de l'invention, il convient encore de noter que le dispositif 1 conforme à l'invention peut être utilisé avantageusement par différents types de systèmes non représentés et embarqués à bord dudit véhicule 3.

Par exemple, un système de référence d'attitude et de cap d'un aéronef, comportant entre autres un magnétomètre pour corriger une éventuelle dérive du cap, peut utiliser le dispositif 1 pour corriger les erreurs dues à des perturbations multiples et variées dans les mesures dudit magnétomètre.

Par ailleurs, une centrale inertielle d'un aéronef, associée à un magnétomètre, peut utiliser le dispositif 1 conforme à l'invention pour déterminer de façon précise, en collaboration avec ledit magnétomètre, la déclinaison et l'inclinaison du champ magnétique terrestre, ainsi que pour corriger les erreurs de mesure dudit magnétomètre.

On présente à présent différents modes de réalisation avantageux permettant de bien mettre en évidence la multiplicité d'utilisations possibles de l'invention. Bien que ces différents modes de réalisation soient précisés les uns après les autres ci-dessous, ils peuvent bien entendu être mis en oeuvre simultanément.

Ainsi, la présente invention est particulièrement bien adaptée à la correction d'erreurs de mesure du magnétomètre, dues à des déformations de l'élément porteur sur lequel est monté ledit magnétomètre. De telles déformations sont susceptibles d'entraîner de légers déplacements du magnétomètre, provoquant en particulier un défaut d'alignement du trièdre de référence de ce dernier par rapport au trièdre de référence du véhicule, ce qui est source d'erreurs.

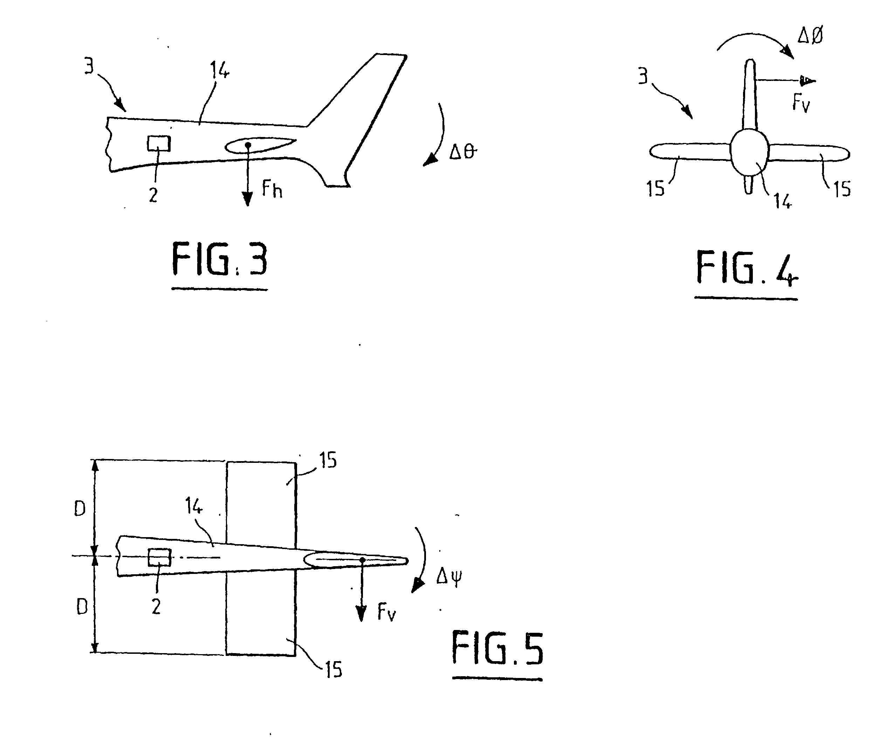

On sait que, dans le cas d'un hélicoptère 3, le magnétomètre 2 est généralement monté dans la poutre de queue 14, tel que représenté sur les figures 3 à 5, de manière à être le plus éloigné possible des principaux équipements électriques et électroniques et des organes massifs de l'hélicoptère 3, susceptibles de perturber ledit magnétomètre 2. Toutefois, comme la poutre de queue 14 n'est pas parfaitement rigide, elle se déforme sous l'effet des contraintes mécaniques auxquelles elle est soumise, ce qui peut entraîner un défaut d'alignement dudit magnétomètre 2.

On sait en outre qu'une erreur d'alignement en assiette se répercute au double sur l'erreur de cap, dans le cas d'une inclinaison de 60° du champ terrestre, telle qu'existant par exemple en France. Comme les déformations observées sont de l'ordre de 0,2°, l'erreur résultante en cap est de l'ordre de 0,4°, cette valeur correspondant environ à la performance recherchée sur les centrales de référence d'attitude et de cap actuelles. Une telle erreur n'est donc pas négligeable.

Généralement, la poutre de queue 14 est soumise à un effort latéral Fv. Le couple rotor principal de l'hélicoptère 3 provoque alors, sur ladite poutre de queue 14 :

- d'une part, une flexion en lacet $\Delta\psi$ représentée sur la figure 5 et vérifiant la relation $\Delta\psi$ = Cez.Fv, Cez étant le coefficient d'élasticité de flexion en lacet de la poutre de queue 14 ; et
- d'autre part, une torsion en roulis $\Delta\Phi$ représentée sur la 5 figure 4 et vérifiant la relation $\Delta\Phi$ = Cex.Fv, Cex étant le coefficient d'élasticité de torsion de la poutre de queue 14.

De plus, dans le cas d'un hélicoptère dont l'empennage 15 présente une symétrie latérale, c'est-à-dire avec des envergures identiques à gauche et à droite, de longueur D, comme représenté sur la figure 5, l'effort vertical (ou la portance) Fh de cet empennage provoque une flexion en tangage $\Delta\Theta$ représentée sur la figure 3 et vérifiant la relation $\Delta\Theta$ = Cey.Fh, Cey étant le coefficient d'élasticité de flexion en tangage de la poutre de queue 14.

Par conséquent, les valeurs $\Delta\psi$, $\Delta\Theta$, $\Delta\Phi$ représentent les variations angulaires de la position du magnétomètre, respectivement en lacet, tangage et roulis, dans le cas où la poutre de queue 14 est soumise aux contraintes précitées, par rapport à la position existant lorsque la poutre de queue 14 est hors contrainte.

Selon l'invention, pour determiner et corriger les erreurs dues à de telles déformations dans les mesures du magnétomètre, on utilise dans le modèle théorique (1) le produit des matrices [C] de dimension (3,5) et [E] de dimension (5,1) telles que :

$$[C] = \begin{bmatrix} 0 & -Cez & 0 & 0 & Cey \\ Cez & 0 & -Cex & 0 & 0 \\ 0 & Cex & 0 & -Cey & 0 \end{bmatrix}$$

et

$$[E] = \begin{bmatrix} Fv.Hmx \\ Fv.Hmy \\ Fv.Hmz \\ Fh.Hmx \\ Fh.Hmz \end{bmatrix}$$

avec Hmx, Hmy et Hmz, les composantes respectives du champ mesuré Hm dans le référentiel du véhicule R1.

Par conséquent, les coefficients de la matrice [C] sont déterminés par le procédé conforme à l'invention et ceux de la matrice [E] par le module de calcul 5 à partir de mesures effectuées de manière connue. A cet effet, ledit module de calcul 5 est relié par l'intermédiaire d'une liaison non représentée au magnétomètre 2 pour recevoir lesdites composantes du champ mesuré Hm.

Le produit [C].[E] constitue donc un vecteur de correction des erreurs de mesure du champ magnétique, provoquées par les contraintes citées précédemment.

Ce vecteur de correction peut être défini, pour bien expliciter la précision de la correction obtenue, à partir d'une matrice [Msd] permettant de passer de la position du magnétomètre 2, lorsque la poutre de queue 14 est hors contrainte, à la position dudit magnétomètre 2, lorsque ladite poutre de queue 14 est sous contrainte. Cette matrice vaut :

$$[\text{Msd}] \quad = \quad \begin{bmatrix} 1 & -\Delta\psi & \Delta\Theta \\ \Delta\psi & 1 & -\Delta\Phi \\ -\Delta\Theta & \Delta\Phi & 1 \end{bmatrix}$$

de sorte que le champ corrigé Hc s'écrit alors, selon l'expression (2) précisée ci-dessus du modèle théorique, Hc = [Msd].[M].H

En négligeant les infiniment petits du second ordre, il subsiste un terme :

$$\begin{bmatrix} 0 & -\Delta\psi & \Delta\Theta \\ \Delta\psi & 0 & -\Delta\Phi \\ -\Delta\Theta & \Delta\Phi & 0 \end{bmatrix} . H$$

qui correspond à :

$$\begin{bmatrix} 0 & -Cez.Fv & Cey.Fh \\ Cez.Fv & 0 & -Cex.Fv \\ -Cey.Fh & Cex.Fv & 0 \end{bmatrix} . \begin{bmatrix} Hmx \\ Hmy \\ Hmz \end{bmatrix} = [C].[E]$$

Ces explications permettent de préciser ce que représente le vecteur de correction obtenu par le procédé conforme à l'invention et susceptible d'être appliqué essentiellement dans le cas d'un hélicoptère dont la poutre de queue porte le magnétomètre.

En revanche, dans le cas d'un avion non représenté, par exemple un avion de transport, le magnétomètre est généralement installé à l'extrémité d'une aile également pour être éloigné le plus possible d'éléments perturbateurs. Or, en raison de l'élasticité de la structure de ladite aile, celle-ci est susceptible d'être déformée, ce qui peut provoquer également un défaut d'alignement du magnétomètre.

La déformation principale existante et prise en compte dans la présente invention est la déformation en battement de ladite aile $\Delta\Phi^*$.

Cette déformation en battement $\Delta\Phi^*$, qui est due à la portance de l'aile Pz, s'écrit $\Delta\Phi^* = Cox.Pz$, Cox étant le coefficient d'élasticité en battement de l'aile.

Selon l'invention, pour déterminer et corriger les erreurs dues à un défaut d'alignement du magnétomètre provoqué par le battement de l'aile portant ledit magnétomètre, on utilise dans le modèle théorique (1) le produit des matrires [C] et [E], telles que

$$[C] = \begin{bmatrix} 0 & 0 \\ -Cox & 0 \\ 0 & Cox \end{bmatrix} \quad \text{et} \quad [E] = \begin{bmatrix} Pz.Hmz \\ Pz.Hmy \end{bmatrix}$$

La portance Pz vérifie la relation

$$Pz = M^*.gz$$

dans laquelle :

- M* représente la masse de l'avion, pouvant être déterminée à partir de la masse initiale dudit avion, de la consommation de carburant et, le cas échéant, de largages d'emports ; et
- gz est le facteur de charge vertical susceptible d'être mesuré par un accéléromètre du système de référence d'attitude et de cap ou de la centrale inertielle de l'avion.

Ces données sont bien entendu transmises par la liaison 6 au module de calcul 5 qui est susceptible de calculer les coefficients de ladite matrice [E].

On notera que le produit [C].[E] vérifie la relation :

$$[C].[E] = \begin{bmatrix} 0 & 0 & 0 \\ 0 & 0 & -Cox.M.gz \\ 0 & Cox.M.gz & 0 \end{bmatrix} \cdot \begin{bmatrix} Hmx \\ Hmy \\ Hmz \end{bmatrix}$$

ce qui permet de faire le rapprochement avec la solution précisée précédemment dans le cas d'un hélicoptère.

On vient de décrire ci-dessus deux modes de réalisation avantageux permettant de corriger des erreurs de mesure du magnétomètre dues à des perturbations mécaniques, à savoir des déformations de l'élément porteur. On décrit à présent ci-dessous plusieurs modes de réalisation permettant de corriger des erreurs dues à différentes perturbations d'origine magnétique.

Un mode de réalisation, particulièrement avantageux et s'appliquant à un hélicoptère, permet de remédier aux instabilités magnétiques provoquées par le rotor de l'hélicoptère qui, d'une part, présente un résidu de magnétisation et, d'autre part, est soumis à des contraintes mécaniques élevées.

Comme le rotor d'un hélicoptère subit généralement en phase de fabrication des contrôles non destructifs de type magnétoscopie, il subsiste en effet souvent sur celui-ci un résidu de magnétisation.

Or, de façon connue, un matériau ferromagnétique aimanté soumis à de fortes contraintes voit son état magnétique varier de façon réversible et proportionnelle aux contraintes appliquées.

Ce phénomène transposé au cas d'un rotor d'hélicoptère peut provoquer des perturbations magnétiques susceptibles d'engendrer des erreurs de mesure non négligeables lorsqu'il s'agit d'un petit hélicoptère sur lequel le magnétomètre ne peut être éloigné suffisamment du mât rotor.

Selon l'invention, pour déterminer et corriger de telles erreurs, on utilise dans le modèle théorique (1) du procédé conforme à l'invention le produit des matrices [C] et [E], telles que

$$[C] = \begin{bmatrix} Hcx \\ Hcy \\ Hcz \end{bmatrix} \quad et \quad [E] = Cr,$$

Cr étant le couple rotor et Hcx, Hcy et Hcz des coefficients de proportionnalité à déterminer par ledit procédé, de manière à obtenir un vecteur de correction défini par ledit produit [C].[E].

Un autre mode de réalisation de l'invention permet de déterminer et de corriger des erreurs dues à des perturbations magnétiques engendrées par la présence d'équipements consommateurs de courant continu à proximité dudit magnétomètre. On sait que, généralement, les deux câbles d'une alimentation électrique cheminent au plus proche l'un de l'autre ou sont torsadés de manière que la surface du circuit ainsi constitué soit la plus faible possible et que le passage de courant n'engendre pas de champ magnétique. Toutefois, de telles précautions de montage ne sont pas toujours possibles, de sorte qu'il apparaît alors un champ magnétique perturbateur.

Selon l'invention, pour corriger un tel champ perturbateur, on détermine un terme correcteur [C].[E] avec :

$$[C] = \begin{bmatrix} Hix \\ Hiy \\ Hiz \end{bmatrix} \quad \text{et} \quad [E] = I,$$

I étant le courant continu consommé par ledit équipement non représenté et Hix, Hiy et Hiz étant des coefficients de proportionnalité déterminés par l'invention.

Bien entendu, dans ce cas, un dispositif de mesure du courant I, relié au module de calcul 5, est nécessaire pour la mise en oeuvre de l'invention.

Les erreurs de mesure peuvent, par ailleurs, provenir d'un défaut de linéarité des voies de mesure et d'acquisition du champ magnétique du magnétomètre. On sait que le fonctionnement d'un magnétomètre est généralement basé sur la compensation du champ à mesurer par un courant continu de sorte que le matériau constituant le noyau des capteurs du magnétomètre fonctionne toujours par rapport au même état de magnétisation, ce qui garantit en principe une assez bonne linéarité. Or, il arrive en pratique, pour certaines conditions de fonctionnement particulières, que cette linéarité ne soit pas vérifiée.

Aussi, pour corriger les erreurs de mesure susceptibles d'être provoquées par un tel défaut de linéarité, on détermine, selon l'invention, une approximation polynomiale de la fonction non linéaire reproduisant ce défaut de linéarité et, pour obtenir le terme correcteur d'une harmonique $\underline{n}$ de ladite approximation polynomiale, on utilise dans le modèle théorique (1) du procédé conforme à l'invention le produit des matrices [C] et [E], telles que

$$[C] = \begin{bmatrix} axn & 0 & 0 \\ 0 & ayn & 0 \\ 0 & 0 & azn \end{bmatrix} \quad \text{et} \quad [E] = \begin{bmatrix} Hmx^n \\ Hmy^n \\ Hmz^n \end{bmatrix}$$

avec :

- axn, ayn et azn des coefficients à déterminer, représentant les amplitudes respectives, selon les trois axes de mesure possibles du magnétomètre 2, des corrections de non-linéarité d'ordre $\underline{n}$ ; et
- $Hmx^n$, $Hmy^n$ et $Hmz^n$ les puissances $n^{\text{ièmes}}$ des composantes respectives du champ mesuré Hm selon les trois axes de mesure du magnétomètre.

Bien entendu, dans le procédé conforme à l'invention et précisé ci-dessus, on a supposé que le champ magnétique mesuré est constant tout au long des différentes manoeuvres du véhicule effectuées pour la mise en oeuvre dudit procédé. Ceci est généralement vérifié en pratique, puisque :

- les manoeuvres effectuées sont limitées, par exemple à deux virages à 30° de roulis, à gauche et à droite, de sorte que le territoire parcouru par le véhicule n'est pas trop important ; et
- la variation du champ terrestre est, dans la plupart des régions du globe terrestre, négligeable pour les variations de position obtenues par de telles manoeuvres.

Toutefois, il peut arriver que, dans certaines régions du globe terrestre, les variations du champ magnétique ne soient pas négligeables, lorsque le territoire parcouru au cours des mesures est relativement important, ce qui peut entraîner des erreurs dans le modèle correcteur obtenu. Dans la présente invention, on tient compte uniquement des variations linéaires dudit champ magnétique.

Ainsi, selon l'invention, pour déterminer les variations locales linéaires des composantes du champ magnétique terrestre, permettant d'améliorer la précision du modèle correcteur, on utilise dans le modèle théorique le produit de la matrice [C], dont les coefficients représentent les différents gradients desdites composantes du champ magnétique, et de la matrice [E], dont les coefficients sont définis à partir des coefficients de la matrice de passage [M] et à partir de la position dans un repère déterminé du véhicule 3 lors des mesures du magnétomètre 2.

En effet, le champ magnétique terrestre H, dont les variations sont localement linéaires, peut s'écrire sous la forme :

$$H = \begin{bmatrix} gnn & gne & gnv \\ gen & gee & gev \\ gvn & gve & gvv \end{bmatrix} \cdot \begin{bmatrix} pn \\ pe \\ pv \end{bmatrix} + \begin{bmatrix} Hn0 \\ He0 \\ Hv0 \end{bmatrix}$$

dans laquelle :

- (pn, pe, pv) représente le vecteur position du véhicule 3 dans un repère déterminé défini par rapport à une position initiale (0, 0, 0), par exemple la position au début des mesures ;
- les vecteurs lignes de la matrice (3x3) sont les gradients respectivement des trois composantes du champ magnétique terrestre ; et
- (Hn0, He0, Hv0) est le champ terrestre à ladite position initiale (0, 0, 0),

de sorte que :

$$[M].H = [M].\left( \begin{bmatrix} gnn & gne & gnv \\ gen & gee & gev \\ gvn & gve & gvv \end{bmatrix} \cdot \begin{bmatrix} pn \\ pe \\ pv \end{bmatrix} + \begin{bmatrix} Hn0 \\ He0 \\ Hv0 \end{bmatrix} \right)$$

$$= [M].\left( \begin{bmatrix} gnn & gne & gnv \\ gen & gee & gev \\ gvn & gve & gvv \end{bmatrix} \cdot \begin{bmatrix} pn \\ pe \\ pv \end{bmatrix} \right) + [M].\begin{bmatrix} Hn0 \\ He0 \\ Hv0 \end{bmatrix}$$

De cette expression, on déduit le terme correctif :

$$\begin{bmatrix} R_{11} & R_{12} & R_{13} \\ R_{21} & R_{22} & R_{23} \\ R_{31} & R_{32} & R_{33} \end{bmatrix} \cdot \begin{bmatrix} gnn & gne & gnv \\ gen & gee & gev \\ gvn & gve & gvv \end{bmatrix} \cdot \begin{bmatrix} pn \\ pe \\ pv \end{bmatrix}$$

qui permet de retrouver par simple transcription matricielle le produit [C].[E] défini précédemment :

$$[C] \cdot [E] = - \begin{bmatrix} R_{11} & R_{12} & R_{13} \\ R_{21} & R_{22} & R_{23} \\ R_{31} & R_{32} & R_{33} \end{bmatrix} \cdot \begin{bmatrix} gnn & gne & gnv \\ gen & gee & gev \\ gvn & gve & gvv \end{bmatrix} \cdot \begin{bmatrix} pn \\ pe \\ pv \end{bmatrix}$$

La matrice [C] apparaît sous la forme donnée ci-après, ayant 3 lignes et 27 colonnes.

$$[C] = \begin{vmatrix} gnn & gne & gnv & gen & gee & gev & gvn & gve & gvv & 0 & 0 & 0 & 0 & 0 & 0 & 0 & 0 & 0 & 0 & 0 & 0 & 0 & 0 & 0 & 0 & 0 & 0 \\ 0 & 0 & 0 & 0 & 0 & 0 & 0 & 0 & 0 & gnn & gne & gnv & gen & gee & gev & gvn & gve & gvv & 0 & 0 & 0 & 0 & 0 & 0 & 0 & 0 & 0 \\ 0 & 0 & 0 & 0 & 0 & 0 & 0 & 0 & 0 & 0 & 0 & 0 & 0 & 0 & 0 & 0 & 0 & 0 & gnn & gne & gnv & gen & gee & gev & gvn & gve & gvv \end{vmatrix}$$

Quant à elle, la matrice [E] présente 1 colonne et 27 lignes, telle que ci-dessous :

$$[E] = \begin{bmatrix} R_{11} & pn \\ R_{11} & pe \\ R_{11} & pv \\ R_{12} & pn \\ R_{12} & pe \\ R_{12} & pv \\ R_{13} & pn \\ R_{13} & pe \\ R_{13} & pv \\ R_{21} & pn \\ R_{21} & pe \\ R_{21} & pv \\ R_{22} & pn \\ R_{22} & pe \\ R_{22} & pv \\ R_{23} & pn \\ R_{23} & pe \\ R_{23} & pv \\ R_{31} & pn \\ R_{31} & pe \\ R_{31} & pv \\ R_{32} & pn \\ R_{32} & pe \\ R_{32} & pv \\ R_{33} & pn \\ R_{33} & pe \\ R_{33} & pv \end{bmatrix}$$

Par ailleurs, la présente invention permet de déterminer et de corriger les biais de gyromètres utilisés en particulier pour déterminer les coefficients de la matrice de passage [M] du référentiel de base R2 au référentiel du véhicule R1.

Le mode de réalisation concerné s'applique plus précisément aux biais gyrométriques qui sont fixes dans le référentiel du véhicule R1, comme par exemple les biais gyrométriques susceptibles d'exister dans les mesures effectuées par une centrale inertielle à composants liés.

A cet effet, selon l'invention, pour déterminer et corriger de tels biais gyrométriques, on utilise dans le modèle théorique (1) le produit des matrices [C] et [E], telles que

$$[C] \doteq \begin{bmatrix} 0 & -\Delta wz & \Delta wy \\ \Delta wz & 0 & -\Delta wx \\ -\Delta wy & \Delta wx & 0 \end{bmatrix} \quad \text{et} \quad [E] = \begin{bmatrix} Hmx.t \\ Hmy.t \\ Hmz.t \end{bmatrix}$$

dans lesquels :

- $\Delta wx$, $\Delta wy$, $\Delta wz$ sont les biais desdits gyromètres à déterminer ; et
- $t$ est l'instant auquel est effectuée la mesure.

Les corrections de biais gyrométriques effectuées ainsi permettent en particulier d'améliorer le modèle correcteur déterminé par le procédé conforme à l'invention. Elles permettent également d'utiliser sur le véhicule 3 des gyromètres de performance moyenne et de coût réduit, pour lesquels la précision des mesures est limitée en raison de l'existence de biais, puisque grâce à l'invention on est en mesure de corriger de tels biais gyrométriques.

Les différents modes de réalisation avantageux décrits précédemment permettent de bien mettre en évidence la multiplicité de corrections possibles et les nombreux avantages de la présente invention. Ces différents modes de réalisation peuvent bien entendu être réalisés simultanément, à partir d'une seule mise en oeuvre du procédé conforme à l'invention, dans le cas où le magnétomètre est soumis à toutes les perturbations citées précédemment. On notera en outre que l'invention n'est évidemment pas limitée à ces modes de réalisation particuliers, mais qu'elle englobe toutes les déterminations et corrections d'erreurs dans les mesures d'un magnétomètre, susceptibles d'être réalisées par le procédé conforme à l'invention telle que definie dans les revendications.

**Revendications**

1. Procédé pour déterminer et corriger des erreurs dues à des perturbations dans les mesures d'un magnétomètre (2) monté à bord d'un véhicule (3), procédé selon lequel :

   - on définit un modèle théorique correcteur des erreurs de mesure du magnétomètre de la forme :

$$Hc = [A].Hm + \sum_{i=1}^{i=n} ( [C]i.[E]i ) + Hp,$$

   $\underline{n}$ étant un nombre entier supérieur ou égal à 1,
   dans lequel :

   . Hc est le champ corrigé,
   . [A] est une matrice à déterminer,
   . Hm est la valeur mesurée par le magnétomètre (2) du champ magnétique dans un référentiel (R1) lié audit véhicule (3),
   . les éléments [C]i sont des matrices à déterminer de dimensions respectives 3 x mi, $\underline{mi}$ étant un nombre entier supérieur ou égal à 1,
   . les éléments [E]i sont des matrices de dimensions respectives mi x 1 dont les coefficients sont des mesures de paramètres perturbateurs ou des combinaisons de telles mesures, et
   . Hp est un champ perturbateur à déterminer ;

   - on considère que le champ corrigé Hc est le champ terrestre défini dans le référentiel du véhicule de sorte que :

$$[A].Hm + \sum_{i=1}^{i=n} ([C]i. [E]i) + Hp = [M].H$$

   avec :

   . H étant la valeur effective du champ magnétique dans un référentiel de base (R2), et
   . [M] étant une matrice de passage dudit référentiel de base (R2) audit référentiel du véhicule (R1) ;

   - on effectue des mesures Hm successives du champ magnétique au moyen du magnétomètre lors d'évolutions du véhicule ;

   - on détermine les coefficients des différentes matrices [E]i, à partir des mesures des paramètres perturbateurs, effectuées simultanément aux mesures Hm ;

   - on détermine les coefficients de la matrice de passage [M] ;

- on définit un vecteur d'erreur E de composantes Ex, Ey et Ez, défini par la relation :

$$E = [M].H - ([A].Hm + \sum_{i=1}^{i=n} ([C]i.[E]i) + Hp)$$

- on définit une erreur globale $E^2 = Ex^2 + Ey^2 + Ez^2$ ;

- on définit un système d'équations formé de $\underline{m}$ équations du type $(\partial\Sigma E^2)/\partial cl = 0$, $1 = 1$ à m, $(\partial\Sigma E^2)/\partial cl$ correspondant à la dérivée partielle de la somme des erreurs globales $\Sigma E^2$, pour toutes les mesures, par rapport à un coefficient $\underline{cl}$, les différents coefficients $\underline{cl}$ représentant les coefficients à déterminer dudit modèle théorique, à savoir les coefficients de la matrice [A], des matrices [C]i et du vecteur Hp, ainsi qu'au moins une composante du champ magnétique effectif H ;

- on résout ledit système d'équations de manière à obtenir lesdits coefficients $\underline{cl}$, y compris ladite composante du champ magnétique effectif H ; et

- on utilise le modèle correcteur obtenu à partir desdits coefficients pour corriger les erreurs dues à des perturbations déterminées dans les mesures dudit magnétomètre (2).

2. Procédé selon la revendication 1, pour déterminer uniquement la composante verticale du champ magnétique, **caractérisé en ce qu'**on utilise comme erreur globale $E^2 = Ez^2$, de sorte que seuls les coefficients de la troisième ligne de la matrice $[M]^{-1}$ sont utilisés, ladite matrice $[M]^{-1}$ étant la matrice de passage dudit référentiel du véhicule (R1) audit référentiel de base (R2), lesdits coefficients étant déterminés à partir des assiettes dudit véhicule (3).

3. Procédé selon la revendication 1, pour déterminer les trois composantes du champ magnétique, **caractérisé en ce que** les coefficients de la matrice [M] sont déterminés à partir des assiettes, ainsi qu'à partir du cap dudit véhicule (3).

4. Procédé selon la revendication 3, **caractérisé en ce que** ledit cap est un cap géographique.

5. Procédé selon la revendication 3, **caractérisé en ce que** ledit cap est un cap délivré par une centrale d'attitude et de cap en mode gyroscopique libre.

6. Procédé selon l'une quelconque des revendications 1 à 5, le magnétomètre (2) étant monté sur un élément porteur (14) susceptible d'être déformé lors de la variation de contraintes mécaniques agissant sur ledit élément porteur, **caractérisé en ce que**, pour déterminer et corriger les erreurs dues à de telles déformations dans les mesures du magnétomètre (2), on utilise dans le modèle théorique le produit de ladite matrice [C] de dimension (3,5) et de ladite matrice [E] de dimension (5,1), telles que :

$$[C] = \begin{bmatrix} 0 & -Cez & 0 & 0 & Cey \\ Cez & 0 & -Cex & 0 & 0 \\ 0 & Cex & 0 & -Cey & 0 \end{bmatrix}$$

et

$$[E] = \begin{bmatrix} Fv.Hmx \\ Fv.Hmy \\ Fv.Hmz \\ Fh.Hmx \\ Fh.Hmz \end{bmatrix}$$

avec :

- Fv : l'effort latéral engendré sur l'élément porteur (14),
- Fh : l'effort vertical engendré sur l'élément porteur (14),
- Cex : le coefficient d'élasticité de torsion de l'élément porteur (14),
- Cey : le coefficient d'élasticité de flexion en tangage de l'élément porteur (14),
- Cez : le coefficient d'élasticité de flexion en lacet de l'élément porteur (14), et
- Hmx, Hmy et Hmz : les composantes respectives du champ mesuré Hm dans le référentiel du véhicule (R1).

7. Procédé selon la revendication 6,
   ledit véhicule étant un hélicoptère (3) et ledit élément porteur du magnétomètre (2) étant la poutre de queue (14) dudit hélicoptère (3).

8. Procédé selon l'une quelconque des revendications 1 à 5, ledit véhicule étant un avion et le magnétomètre étant monté sur une aile dudit avion,
   **caractérisé en ce que**, pour déterminer et corriger les erreurs dues à un défaut d'alignement du magnétomètre provoqué par le battement de ladite aile portant ledit magnétomètre, on utilise dans le modèle théorique le produit desdites matrices [C] et [E], telles que

$$[C] = \begin{bmatrix} 0 & 0 \\ -Cox & 0 \\ 0 & Cox \end{bmatrix} \quad et \quad [E] = \begin{bmatrix} Pz.Hmz \\ Pz.Hmy \end{bmatrix}$$

dans lesquels :

- Cox est le coefficient d'élasticité en battement de ladite aile,
- Pz est la portance de ladite aile, et
- Hmy et Hmz sont les valeurs des composantes latérale et verticale du champ magnétique mesuré Hm.

9. Procédé selon la revendication 8,
   **caractérisé en ce que** l'on détermine la portance Pz à partir de la relation Pz = M*.gz, avec M* la masse du véhicule et <u>gz</u> le facteur de charge vertical.

10. Procédé selon l'une des revendications 1 à 7, ledit véhicule étant un hélicoptère dont le rotor présente un résidu de magnétisation,
    **caractérisé en ce que**, pour déterminer et corriger les erreurs dues à des variations des perturbations magnétiques provoquées par ledit rotor aimanté soumis à des contraintes mécaniques élevées, on utilise dans le modèle théorique le produit desdites matrices [C] et [E], telles que

$$[C] = \begin{bmatrix} Hcx \\ Hcy \\ Hcz \end{bmatrix} \quad et \quad [E] = Cr,$$

Cr étant le couple rotor et Hcx, Hcy et Hcz des coefficients de proportionnalité à déterminer.

**11.** Procédé selon l'une quelconque des revendications précédentes,
**caractérisé en ce que**, pour déterminer et corriger les erreurs dues à des perturbations magnétiques engendrées par la présence d'au moins un équipement consommateur de courant continu à proximité dudit magnétomètre (2), on utilise dans le modèle théorique le produit desdites matrices [C] et [E], telles que

$$[C] = \begin{bmatrix} Hix \\ Hiy \\ Hiz \end{bmatrix} \qquad \text{et } [E] = I,$$

I étant le courant continu consommé par ledit équipement et Hix, Hiy et Hiz des coefficients de proportionnalité à déterminer.

**12.** Procédé selon l'une quelconque des revendications précédentes,
**caractérisé en ce que**, pour déterminer et corriger un défaut de linéarité des mesures du magnétomètre (2) selon au moins l'un des trois axes de mesure possibles dudit magnétomètre (2), on détermine une approximation polynomiale de la fonction non linéaire reproduisant ce défaut de linéarité, et **en ce que**, pour déterminer le terme correcteur d'une harmonique $\underline{n}$ de ladite approximation polynomiale, on utilise dans le modèle théorique le produit desdites matrices [C] et [E], telles que

$$[C] = \begin{bmatrix} axn & 0 & 0 \\ 0 & ayn & 0 \\ 0 & 0 & azn \end{bmatrix} \qquad \text{et } [E] = \begin{bmatrix} Hmx^n \\ Hmy^n \\ Hmz^n \end{bmatrix}$$

avec :

- axn, ayn et azn, des coefficients à déterminer représentant les amplitudes respectives, selon les trois axes de mesure du magnétomètre (2), des corrections de non-linéarité d'ordre $\underline{n}$ ; et
- Hmxn, $Hmy^n$ et $Hmz^n$, les puissances $n^{\text{ièmes}}$ des composantes respectives du champ mesuré Hm selon les trois axes de mesure du magnétomètre (2).

**13.** Procédé selon l'une quelconque des revendications précédentes,
**caractérisé en ce que**, pour déterminer les variations locales des composantes du champ magnétique terrestre, permettant d'améliorer la précision du modèle correcteur, on utilise dans le modèle théorique le produit de ladite matrice [C], dont les coefficients représentent les différents gradients desdites composantes du champ magnétique terrestre, et de ladite matrice [E], dont les coefficients sont calculés à partir des coefficients de la matrice de passage [M] et à partir de la position dans un repère déterminé dudit véhicule (3) lors des mesures du magnétomètre (2).

**14.** Procédé selon l'une quelconque des revendications précédentes,
**caractérisé en ce que**, pour déterminer et corriger les biais de gyromètres, dont les mesures sont utilisées notamment pour déterminer les coefficients de ladite matrice [M], on utilise dans le modèle théorique le produit desdites matrices [C] et [E], telles que

$$[C] = \begin{bmatrix} 0 & -\Delta wz & \Delta wy \\ \Delta wz & 0 & -\Delta wx \\ -\Delta wy & \Delta wx & 0 \end{bmatrix} \text{et } [E] = \begin{bmatrix} Hmx.t \\ Hmy.t \\ Hmz.t \end{bmatrix}$$

dans lesquels :

- $\Delta$wx, $\Delta$wy et $\Delta$wz sont les biais desdits gyromètres à déterminer,
- Hmx, Hmy et Hmz sont les composantes respectives du champ mesuré Hm dans le référentiel du véhicule (R1), et
- t est l'instant auquel est effectuée la mesure.

**15.** Dispositif adapté à la mise en oeuvre du procédé spécifié sous l'une quelconque des revendications 1 à 14, **caractérisé en ce qu'**il comporte :

- un premier module de calcul (5) recevant des données disponibles sur ledit véhicule (3) et susceptible de déterminer à partir de ces données les coefficients des matrices [E]i ;
- un second module de calcul (7) susceptible de calculer les coefficients de la matrice de passage [M], à partir des assiettes et du cap du véhicule (3) ; et
- un module principal de calcul (10) relié auxdits premier et second modules de calcul (5, 7), ainsi qu'au magnétomètre (2), et susceptible de déterminer ledit modèle correcteur et au moins une composante du champ magnétique effectif.

**16.** Dispositif selon la revendication 15, **caractérisé en ce que** ledit module principal de calcul (10) et lesdits premier et second modules de calcul (5, 7) sont implantés dans des calculateurs différents.

**17.** Système de référence d'attitude et de cap embarqué à bord d'un aéronef (3) et comportant un magnétomètre (2) pour corriger une éventuelle dérive de la mesure du cap, **caractérisé en ce qu'**il comporte le dispositif (1) spécifié sous l'une des revendications 15 ou 16, ledit dispositif (1) étant utilisé pour corriger les erreurs de mesure dudit magnétomètre.

**18.** Centrale inertielle d'un aéronef (3), associée à un magnétomètre (2), **caractérisée en ce qu'**elle comporte le dispositif (1) spécifié sous l'une des revendications 15 ou 16, ledit dispositif (1) étant utilisé pour déterminer, en collaboration avec ledit magnétomètre, le champ magnétique terrestre, ainsi que pour corriger les erreurs de mesure dudit magnétomètre.


**Patentansprüche**

**1.** Verfahren zum Ermitteln und Korrigieren von Fehlern, die auf Störungen in den Messungen eines Magnetometers (2) zurückzuführen sind, welches an Bord eines Fahrzeugs (3) montiert ist, wobei gemäß diesem Verfahren:

- man ein theoretisches Korrekturmodell für Messfehler des Magnetometers in der folgenden Form definiert:

$$\text{Hc} = [A].\text{Hm} + \sum_{i=1}^{i=n} ([C]i.[E]i) + \text{Hp},$$

wobei n eine ganze Zahl größer oder gleich 1 ist,
darin sind:

* Hc das korrigierte Feld,

* [A] eine zu ermittelnde Matrix,

* Hm der vom Magnetometer (2) in einem mit dem besagten Fahrzeug (3) verbundenen Bezugssystem (R1) gemessene Wert des Magnetfeldes,

* die Elemente [C]i zu ermittelnde Matrizen mit den jeweiligen Abmessungen 3 x mi, wobei mi eine ganze Zahl größer oder gleich 1 ist,

\* die Elemente [E]i Matrizen mit den jeweiligen Abmessungen mi x 1, deren Koeffizienten Messwerte von Störparametern oder Kombinationen derartiger Messwerte sind, und

\* Hp ein zu ermittelndes Störfeld;

- man geht davon aus, dass das korrigierte Feld Hc das terrestrische Feld ist, welches im Bezugssystem des Fahrzeugs folgendermaßen definiert ist:

$$[A].Hm + \sum_{i=1}^{i=n} ([C]i.[E]i) + Hp = [M].H$$

wobei:

\* H der Effektivwert des Magnetfeldes in einem Basis-Bezugssystem (R2) ist und

\* [M] eine Matrix des Übergangs vom besagten Basis-Bezugssystem (R2) zum Bezugssystem des Fahrzeugs (R1) ist;

- man führt aufeinanderfolgende Hrn-Messungen des Magnetfeldes mittels des Magnetometers bei Bewegungen des Fahrzeugs durch;

- man ermittelt die Koeffizienten der verschiedenen Matrizen [E]i auf der Grundlage der Messungen der Störparameter, die gleichzeitig mit den Hm-Messungen durchgeführt werden;

- man ermittelt die Koeffizienten der Übergangsmatrix [M];

- man definiert einen Fehlervektor E mit den Komponenten Ex, Ey und Ez, der durch die folgende Beziehung festgelegt wird:

$$E = [M].H - ([A].Hm + \sum_{i=1}^{i=n} ([C]i.[E]i) + Hp)$$

- man definiert einen Globalfehler $E^2 = Ex^2 + Ey^2 + Ez^2$;

- man definiert ein Gleichungssystem aus $\underline{m}$ Gleichungen vom Typ $(\partial\Sigma E^2)/\partial cl = 0$, 1 = 1 bis m, wobei $(\partial\Sigma E^2)/\partial cl$ der partiellen Ableitung der Summe der Globalfehler $\Sigma E^2$ nach einem Koeffizienten $\underline{cl}$ ist, wobei die verschiedenen Koeffizienten $\underline{cl}$ den zu ermittelnden Koeffizienten des besagten theoretischen Modells entsprechen, nämlich den Koeffizienten der Matrix [A], der Matrizen [C]i und des Vektors Hp sowie mindestens einer Komponente des effektiven Magnetfeldes H;

- man löst das besagte Gleichungssystem, um die besagten Koeffizienten $\underline{cl}$ zu erhalten einschließlich der besagten Komponente des effektiven Magnetfeldes H; und

- man benutzt das auf der Grundlage der besagten Koeffizienten erhaltene Korrekturmodell, um die Fehler zu korrigieren, die auf Störungen zurückzuführen sind, die bei den Messungen des besagten Magnetfeldes (2) ermittelt werden.

2. Verfahren nach Anspruch 1, um einzig und allein die Vertikalkomponente des Magnetfeldes zu ermitteln, **dadurch gekennzeichnet, dass** man als Globalfehler den Ausdruck $E^2 = Ez^2$ dergestalt benutzt, dass lediglich die Koeffizienten der dritten Zeile der Matrix $[M]^{-1}$ benutzt werden, wobei die besagte Matrix $[M]^{-1}$ die Matrix für den Übergang vom besagten Bezugssystem des Fahrzeugs (R1) zum Basis-Bezugssystem (R2) ist und die besagten Koeffizienten auf der Grundlage der Trimmungswerte des besagten Fahrzeugs (3) ermittelt werden.

3. Verfahren nach Anspruch 1 zur Ermittlung der drei Komponenten des Magnetfeldes,
**dadurch gekennzeichnet, dass** die Koeffizienten der Matrix [M] auf der Grundlage der Trimmungswerte sowie auf der Grundlage des Kurses des besagten Fahrzeugs (3) ermittelt werden.

4. Verfahren nach Anspruch 3,
**dadurch gekennzeichnet, dass** der besagte Kurs ein geografischer Kurs ist.

5. Verfahren nach Anspruch 3,
**dadurch gekennzeichnet, dass** der besagte Kurs ein Kurs ist, der von einem Zentrum für Fluglage und Kurs im Modus des kräftefreien Kreisels geliefert wird.

6. Verfahren nach einem der Ansprüche 1 bis 5, wobei das Magnetometer (2) auf ein Tragelement (14) montiert ist, welches sich bei der Änderung der mechanischen Beanspruchungen, die auf das besagte Tragelement wirken, verformen kann,
**dadurch gekennzeichnet, dass** man zur Ermittlung und Korrektur der auf diese Verformungen zurückzuführenden Fehler bei den Messungen des Magnetometers (2) in dem theoretischen Modell das Produkt aus der Matrix [C] mit der Abmessung (3,5) und der Matrix [E] mit der Abmessung (5,1) benutzt, welche die Form haben:

$$[C] \; = \; \begin{bmatrix} 0 & -Cez & 0 & 0 & Cey \\ Cez & 0 & -Cex & 0 & 0 \\ 0 & Cex & 0 & -Cey & 0 \end{bmatrix}$$

und

$$[E] \; = \; \begin{bmatrix} Fv \, . \, Hmx \\ Fv \, . \, Hmy \\ Fv \, . \, Hmz \\ Fh \, . \, Hmx \\ Fh \, . \, Hmz \end{bmatrix} .$$

mit:

- Fv: seitliche Beanspruchung, die auf das Tragelement (14) wirkt,

- Fh: vertikale Beanspruchung, die auf das Tragelement (14) wirkt,

- Cex: Elastizitätsmodul der Torsion des Tragelements (14),

- Cey: Elastizitätsmodul der Biegung beim Nicken des Tragelements (14),

- Cez: Elastizitätsmodul der Biegung beim Gieren des Tragelements (14) und

- Hmx, Hmy und Hmz: die jeweiligen Komponenten des im Bezugssystem des Fahrzeugs (R1) gemessenen Feldes Hm.

**7.** Verfahren nach Anspruch 6,
bei welchem das besagte Fahrzeug ein Hubschrauber (3) und das besagte Tragelement für das Magnetometer (2) der Leitwerksträger (14) des besagten Hubschraubers (3) sind.

**8.** Verfahren nach einem der Ansprüche 1 bis 5, wobei das besagte Fahrzeug ein Flugzeug ist und das Magnetometer auf einen Flügel des besagten Flugzeugs montiert ist,
**dadurch gekennzeichnet, dass** man zur Ermittlung und Korrektur der Fehler, die auf einen Fehler in der Ausrichtung des Magnetometers zurückzuführen sind, welche durch das Schlagen des besagten, das Magnetometer tragenden Flügels hervorgerufen werden, in dem theoretischen Modell das Produkt aus den besagten Matrizen [C] und [E] benutzt, die wie folgt aussehen:

$$[C] = \begin{bmatrix} 0 & 0 \\ -Cox & 0 \\ 0 & Cox \end{bmatrix} \quad und \quad [E] = \begin{bmatrix} Pz.Hmz \\ Pz.Hmy \end{bmatrix}$$

.

Hierbei sind:

- Cox der Elastizitätsmodul beim Schlagen des besagten Flügels,

- Pz der Auftrieb des besagten Flügels, und

- Hmy und Hmz die Werte der Seiten- und der Vertikalkomponente des gemessenen Magnetfeldes Hm.

**9.** Verfahren nach Anspruch 8,
**dadurch gekennzeichnet, dass** man den Auftrieb Pz auf der Grundlage der Beziehung Pz = M*.gz ermittelt, wobei M* die Masse des Fahrzeugs und gz das vertikale Lastvielfache sind.

**10.** Verfahren nach einem der Ansprüche 1 bis 7, wobei das besagte Fahrzeug ein Hubschrauber ist, dessen Rotor eine Restmagnetisierung aufweist,
**dadurch gekennzeichnet, dass** man zur Ermittlung und Korrektur der Fehler, die auf Veränderungen der magnetischen Störungen zurückzuführen sind, welche vom besagten aufmagnetisierten und erhöhten mechanischen Beanspruchungen ausgesetzten Rotor hervorgerufen werden, in dem theoretischen Modell das Produkt aus den besagten Matrizen [C] und [E] benutzt, die wie folgt aussehen:

.

$$[C] = \begin{bmatrix} Hcx \\ Hcy \\ Hcz \end{bmatrix} \quad und \quad [E] = Cr,$$

wobei Cr das Rotormoment und Hcx, Hcy und Hcz zu ermittelnde Proportionalitätskoeffizienten sind.

**11.** Verfahren nach einem beliebigen der vorangegangenen Ansprüche,
**dadurch gekennzeichnet, dass** man zur Ermittlung und Korrektur der Fehler, die auf magnetische Störungen zurückzuführen sind, welche durch das Vorhandensein von mindestens einem Gleichstromverbraucher in der Nähe des besagten Magnetometers (2) hervorgerufen werden, in dem theoretischen Modell das Produkt aus den besagten Matrizen [C] und [E] benutzt, die wie folgt aussehen:

$$[C] \; = \; \begin{bmatrix} Hix \\ Hiy \\ Hiz \end{bmatrix} \; und \; [E] \; = \; I,$$

wobei I der von der besagten Ausrüstung verbrauchte Gleichstrom und Hix, Hiy und Hiz zu ermittelnde Proportionalitätskoeffizienten sind.

12. Verfahren nach einem beliebigen der vorangegangenen Ansprüche,
**dadurch gekennzeichnet, dass** man zur Ermittlung und Korrektur eines Linearitätsfehlers der Messungen des Magnetometers (2) in mindestens einer der drei möglichen Messachsen des besagten Magnetometers (2) eine Polynom-Approximation der nichtlinearen Funktion ermittelt, welche diesen Linearitätsfehler wiedergibt, und dadurch, dass man zur Ermittlung des Korrekturterms einer Harmonischen $\underline{n}$ der besagten Polynom-Approximation in dem theoretischen Modell das Produkt aus den besagten Matrizen [C] und [E] benutzt, die wie folgt aussehen:

$$[C] \; = \; \begin{bmatrix} axn & 0 & 0 \\ 0 & ayn & 0 \\ 0 & 0 & azn \end{bmatrix} \; und \; [E] \; = \; \begin{bmatrix} Hmx^n \\ Hmy^n \\ Hmz^n \end{bmatrix}$$

wobei:

- axn, ayn und azn die zu ermittelnden Koeffizienten sind, welche in den drei Messachsen des Magnetometers (2) die jeweiligen Amplituden der Korrekturen der Nichtlinearität $\underline{n}$-ter Ordnung darstellen; und

- $Hmx^n$, $Hmy^n$ und $Hmz^n$ die n-ten Potenzen der jeweiligen Komponenten des in den drei Messachsen des Magnetometers (2) gemessenen Feldes Hm sind.

13. Verfahren nach einem beliebigen der vorangegangenen Ansprüche,
**dadurch gekennzeichnet, dass** man zur Ermittlung der lokalen Änderungen der Komponenten des terrestrischen Magnetfeldes, was die Erhöhung der Genauigkeit des Korrekturmodells ermöglicht, in dem theoretischen Modell das Produkt aus der besagten Matrix [C], deren Koeffizienten die verschiedenen Gradienten der besagten Komponenten des Magnetfeldes darstellen, und der besagten Matrix [E], deren Koeffizienten auf der Grundlage der Koeffizienten der Übergangsmatrix [M] und auf der Grundlage der Lage in einem festgelegten Bezugssystem des besagten Fahrzeugs (3) bei den Messungen mit dem Magnetometer (2) berechnet werden, benutzt.

14. Verfahren nach einem beliebigen der vorangegangenen Ansprüche,
**dadurch gekennzeichnet, dass** man zur Ermittlung und Korrektur der Abweichungen der Kreisel, deren Messungen besonders dazu benutzt werden, um die Koeffizienten der besagten Matrix [M] zu ermitteln, in dem theoretischen Modell das Produkt aus den besagten Matrizen [C] und [E] benutzt, die wie folgt aussehen:

$$[C] \; = \; \begin{bmatrix} 0 & -\Delta wz & \Delta wy \\ \Delta wz & 0 & -\Delta wx \\ -\Delta wy & \Delta wx & 0 \end{bmatrix} \; und \; [E] \; = \; \begin{bmatrix} Hmx.t \\ Hmy.t \\ Hmz.t \end{bmatrix}$$

darin sind:

- $\Delta$wx, $\Delta$wy und $\Delta$wz die zu ermittelnden Abweichungen der besagten Kreisel,

- Hmx, Hmy und Hmz die jeweiligen Komponenten des im Bezugssystem des Fahrzeugs (R1) gemessenen Feldes Hm, und

- t der Zeitpunkt, zu dem die Messung durchgeführt wird.

15. Vorrichtung, die für die Anwendung des in einem beliebigen der Ansprüche 1 bis 14 spezifizierten Verfahrens ausgelegt ist,
   **dadurch gekennzeichnet, dass** sie umfasst:

   - einen ersten Rechenmodul (5), der Daten erhält, die über das Fahrzeug (3) verfügbar sind, und imstande ist, auf der Grundlage dieser Daten, die Koeffizienten der Matrizen [E]i zu ermitteln;
   - einen zweiten Rechenmodul (7), der imstande ist, die Koeffizienten der Übergangsmatrix [M] auf der Grundlage der Trimmungs- und Kurswerte des Fahrzeugs (3) zu berechnen; und
   - einen Hauptrechenmodul (10), der mit den besagten Rechenmodulen (5, 7) sowie dem besagten Magnetometer (2) verbunden ist und der imstande ist, das besagte Korrekturmodell und mindestens eine Komponente des effektiven Magnetfeldes zu ermitteln.

16. Vorrichtung nach Anspruch 15,
   **dadurch gekennzeichnet, dass** der besagte Hauptrechenmodul (10) und der besagte erste (5) und der besagte zweite (7) Rechenmodul in unterschiedliche Rechner eingesetzt sind.

17. Bezugssystem für Fluglage und Kurs, welches an Bord eines Luftfahrzeugs (3) installiert ist und ein Magnetometer (2) enthält, um eine eventuelle Abweichung der Kursmessung zu korrigieren,
   **dadurch gekennzeichnet, dass** es die in einem der Ansprüche 15 oder 16 spezifizierte Vorrichtung (1) enthält, wobei die besagte Vorrichtung (1) dazu benutzt wird, die Messfehler des besagten Magnetometers zu korrigieren.

18. Trägheitszentrum eines Luftfahrzeugs (3), welches mit einem Magnetometer (2) verbunden ist,
   **dadurch gekennzeichnet, dass** es die in einem der Ansprüche 15 oder 16 spezifizierte Vorrichtung (1) enthält, wobei die besagte Vorrichtung (1) dazu benutzt wird, um im Zusammenwirken mit dem besagten Magnetometer das terrestrische Magnetfeld zu ermitteln sowie um die Messfehler des besagten Magnetometers zu korrigieren.

**Claims**

1. Method for determining and correcting errors due to perturbations in the measurements of a magnetometer (2) mounted on board a vehicle (3), according to which method:

   - a theoretical model correcting the measurement errors of the magnetometer is defined in the form:

$$Hc = [A].Hm + \sum_{i=1}^{i=n} ([C]i.[E]i) + Hp,$$

   n being an integer greater than or equal to 1, in which:

   - Hc is the corrected field,
   - [A] is a matrix to be determined,
   - Hm is the value measured by the magnetometer (2) of the magnetic field in a reference frame (R1) associated with the said vehicle (3),
   - the elements [C]i are matrices to be determined, with respective dimensions (3 x mi), mi being an integer greater than or equal to 1,
   - the elements [E]i are matrices with respective dimensions (mi x 1), the coefficients of which are measurements of perturbing parameters or combinations of such measurements, and

- • Hp is a perturbing field to be determined;

- - the corrected field Hc is assumed to be the terrestrial field defined in the vehicle reference frame, so that:

$$[A].Hm + \sum_{i=1}^{i=n} ([C]i.[E]i) + Hp = [M].H$$

with:

- • H being the effective value of the magnetic field in a base reference frame (R2), and
- • [M] being a change of frame matrix from the said base reference frame (R2) to the said vehicle reference frame (R1);

- - successive measurements Hm of the magnetic field are taken using the magnetometer during movements of the vehicle;
- - the coefficients of the various matrices [E]i are determined on the basis of the measurements of the perturbing parameters, taken simultaneously with the Hm measurements;
- - the coefficients of the change of frame matrix [M] are determined;
- - an error vector E with components Ex, Ey and Ez is defined, defined by the equation:

$$E = [M].H - ([A].Hm + \sum_{i=1}^{i=n} ([C]i.[E]i) + Hp)$$

- - a general error $E^2 = Ex^2 + Ey^2 + Ez^2$ is defined;
- - a system of equations formed by $\underline{m}$ equations of the type $(\partial \Sigma E^2)/\partial cl = 0$, 1 = 1 to m, $(\partial \Sigma E^2)/\partial cl$ corresponding to the partial derivative of the sum of the general errors $\Sigma E^2$ is defined, for all the measurements, with respect to a coefficient $\underline{cl}$, the various coefficients $\underline{cl}$ representing the coefficients to be determined in the said theoretical model, namely the coefficients of the matrix [A], of the matrices [C]i and of the vector Hp, as well as at least one component of the effective magnetic field H;
- - the said system of equations is solved so as to obtain the said coefficients $\underline{cl}$, including the said component of the effective magnetic field H; and
- - the corrective model obtained on the basis of the said coefficients is used to correct the errors due to determined perturbations in the measurements of the said magnetometer (2).

2. Method according to Claim 1, for determining only the vertical component of the magnetic field, **characterized in that** $E^2 = Ez^2$ is used as general error, so that only the coefficients of the third row of the matrix $[M]^{-1}$ are used, the said matrix $[M]^{-1}$ being the change of frame matrix from the said vehicle reference frame (R1) to the said base reference frame (R2), the said coefficients being determined from the attitudes of the said vehicle (3).

3. Method according to Claim 1, for determining all three components of the magnetic field, **characterized in that** the coefficients of the matrix [M] are determined on the basis of the attitudes as well as on the basis of the heading of the said vehicle (3).

4. Method according to Claim 3, **characterized in that** the said heading is a geographical heading.

5. Method according to Claim 3, **characterized in that** the said heading is a heading delivered by a free gyroscopic mode attitude and heading unit.

6. Method according to any one of Claims 1 to 5, the magnetometer (2) being mounted on a supporting element (14) capable of being deformed when the mechanical stresses acting on the said supporting element vary, **characterized in that**, in order to determine and correct the errors due to such deformations in the measurements of the magnetometer (2), the product of the said matrix [C] of dimension (3,5) and the said matrix [E] of dimension (5,1) are used in the theoretical model, such that:

$$[C] = \begin{bmatrix} 0 & -Cez & 0 & 0 & Cey \\ Cez & 0 & -Cex & 0 & 0 \\ 0 & Cex & 0 & -Cey & 0 \end{bmatrix}$$

and

$$[E] = \begin{bmatrix} Fv.Hmx \\ Fv.Hmy \\ Fv.Hmz \\ Fh.Hmx \\ Fh.Hmz \end{bmatrix}$$

with:

- Fv : the lateral force generated on the supporting element (14),
- Fh : the vertical force generated on the supporting element (14),
- Cex : the torsional elasticity coefficient of the supporting element (14),
- Cey : the pitch flexional elasticity coefficient of the supporting element (14),
- Cez : the yaw flexional elasticity coefficient of the supporting element (14), and
- Hmx, Hmy and Hmz : the respective components of the measured field Hm in the vehicle reference frame (R1).

7. Method according to Claim 6, the said vehicle being a helicopter (3) and the said supporting element of the magnetometer (2) being the tail boom (14) of the said helicopter (3).

8. Method according to any one of Claims 1 to 5, the said vehicle being an aeroplane and the magnetometer being mounted on a wing of the said aeroplane, **characterized in that**, in order to determine and correct the errors due to an alignment defect of the magnetometer caused by flapping of the said wing supporting the said magnetometer, the product of the matrices [C] and [E] is used in the theoretical model such that

$$[C] = \begin{bmatrix} 0 & 0 \\ -Cox & 0 \\ 0 & Cox \end{bmatrix} \quad \text{and} \quad [E] = \begin{bmatrix} Pz.Hmz \\ Pz.Hmy \end{bmatrix}$$

in which:

- Cox is the flapping elasticity coefficient of the said wing,
- Pz is the lift of the said wing, and
- Hmy and Hmz are the values of the lateral and vertical components of the measured magnetic field Hm.

9. Method according to Claim 8, **characterized in that** the lift Pz is determined on the basis of the equation Pz = M*. gz, with M* the mass of the vehicle and gz the vertical load factor.

10. Method acording to any one of Claims 1 to 7, the said vehicle being a helicopter whose rotor has residual magnetization, **characterized in that**, in order to determine and correct the errors due to variations in the magnetic perturbations caused by the said magnetized rotor subjected to high mechanical stresses, the product of the said matrices [C] and [E] is used in the theoretical model such that

$$[C] = \begin{bmatrix} Hcx \\ Hcy \\ Hcz \end{bmatrix} \quad \text{and} \quad [E] = Cr,$$

Cr being the rotor torque and Hcx, Hcy and Hcz proportionality coefficients to be determined.

**11.** Method according to any one of the previous claims, **characterized in that**, in order to determine and correct the errors due to magnetic perturbations generated by the presence of at least one equipment item that consumes direct current in proximity to the said magnetometer (2), the product of the said matrices [C] and [E] is used in the theoretical model such that

$$[C] = \begin{bmatrix} Hix \\ Hiy \\ Hiz \end{bmatrix} \quad \text{and} \quad [E] = I,$$

I being the direct current consumed by the said equipment and Hix, Hiy and Hiz proportionality coefficients to be determined.

**12.** Method according to any one of the previous claims, **characterized in that**, in order to determine and correct a linearity defect in the measurements of the magnetometer (2) along at least one of the three possible measurement axes of the said magnetometer (2), a polynomial approximation of the nonlinear function reproducing this linearity defect is determined, and **in that**, in order to determine the corrective term of a harmonic $\underline{n}$ in the said polynomial approximation, the product of the said matrices [C] and [E] are used in the theoretical model such that

$$[C] = \begin{bmatrix} axn & 0 & 0 \\ 0 & ayn & 0 \\ 0 & 0 & azn \end{bmatrix} \quad \text{and} \quad [E] = \begin{bmatrix} Hmx^n \\ Hmy^n \\ Hmz^n \end{bmatrix}$$

with:

- axn, ayn and azn coefficients, to be determined, representing the respective amplitudes, along the three measurement axes of the magnetometer (2), of the nonlinearity corrections of order $\underline{n}$; and
- $Hmx^n$, $Hmy^n$ and $Hmz^n$, the $n^{th}$ powers of the respective components of the measured field Hm along the three measurement axes of the magnetometer (2).

**13.** Method according to any one of the previous claims, **characterized in that**, in order to determine the local variations in the components of the terrestrial magnetic field, making it possible to improve the precision of the corrective model, the product of the said matrix [C], the coefficients of which represent the various gradients of the said components of the terrestrial magnetic field, and the said matrix [E], the coefficients of which are calculated on the basis of the coefficients of the change of frame matrix [M] and on the basis of the position in a determined reference frame of the said vehicle (3) during measurements by the magnetometer (2), is used in the theoretical model.

**14.** Method according to any one of the previous claims, **characterized in that**, in order to determine and correct the biases of gyrometers, the measurements of which are used, in particular, for determining the coefficients of the said matrix [M], the product of the matrices [C] and [E] is used in the theoretical model such that

$$[C] = \begin{bmatrix} 0 & -\Delta wz & \Delta wy \\ \Delta wz & 0 & -\Delta wx \\ -\Delta wy & \Delta wx & 0 \end{bmatrix} \quad \text{and} \quad [E] = \begin{bmatrix} Hmx.t \\ Hmy.t \\ Hmz.t \end{bmatrix}$$

in which:

- $\Delta wx$, $\Delta wy$ and $\Delta wz$ are the biases of the said gyrometers to be determined,
- Hmx, Hmy and Hmz are the respective components of the measured field Hm in the vehicle reference frame (R1), and
- t̲ is the time at which the measurement is taken.

15. Device adapted to implementing the method specified under any one of Claims 1 to 14, **characterized in that** it includes:

- a first calculation module (5), receiving available data regarding the said vehicle (3) and capable of determining, on the basis of these data, the coefficients of the matrices [E]i;
- a second calculation module (7) capable of calculating the coefficients of the change of frame matrix [M], on the basis of the attitudes and the heading of the vehicle (3); and
- a main calculation module (10), connected to the said first and second calculation modules (5, 7), as well as to the magnetometer (2), and capable of determining the said corrective model and at least one component of the effective magnetic field.

16. Device according to Claim 15, **characterized in that** the said main calculation module (10) and the said first and second calculation modules (5, 7) are installed in different computers.

17. Attitude and heading reference system on board an aircraft (3) including a magnetometer (2) for correcting a possible drift in the heading measurement, **characterized in that** it includes the device (1) specified under either of Claims 15 and 16, the said device (1) being used to correct the measurement errors of the said magnetometer.

18. Inertial unit of an aircraft (3) associated with a magnetometer (2), **characterized in that** it includes the device (1) specified under either of Claims 15 and 16, the said device (1) being used to determine the terrestrial magnetic field in collaboration with the said magnetometer as well as to correct the measurement errors of the said magnetometer.

FIG.1

FIG.2

EP 0 737 866 B1

FIG. 4

$\Delta\emptyset$

Fv

15

14

15

3

FIG. 3

$\Delta\theta$

Fh

14

2

3

FIG. 5

$\Delta\psi$

Fv

15

15

14

2

D

D